# EUROPÄISCHE PATENTANMELDUNG

(11) **EP 2 003 941 A2**
(43) Veröffentlichungstag der Anmeldung: **17.12.2008**
(21) Anmeldenummer: 08157404.8
(22) Anmeldetag: 02.06.2008
(51) Int. Cl.: H05K 3/10

(54) **Drucktechnisch hergestellte funktionale Komponenten**

(30) Priorität: 14.06.2007 DE 102007027473
(71) Anmelder: manroland AG, 63075 Offenbach/Main (DE); maris TechCon, 8020 Graz (AT)
(72) Erfinder: Walther, Thomas, 63067, Offenbach (DE); Dr. Riester, Markus, 8054, Seiersberg (AT); Werber, Edgar, 63075, Offenbach (DE); Lorenz, Andreas, 63067, Offenbach (DE)
(74) Vertreter: Stahl, Dietmar

(57) **Zusammenfassung**

Es soll eine einfache und kantengenaue Herstellung einer drucktechnisch erzeugten funktionalen Schicht durch strukturiertes Vordrucken eines Klebers in einem Druckwerk oder eine Druckvorrichtung auf einem beliebigen Substrat ermöglicht werden. Die Funktionalität wird im Wesentlichen durch das Bestäuben der Kleberschicht mit pulvrigen funktionalen Partikeln erzeugt.

Erfindungsgemäß wird die drucktechnisch und durch Bestäubung erzeugte strukturierte Schicht als Bestandteil einer Multilayeranordnung, z.B. in einer Leiterplatte verwendet und umfasst neben der ersten mindestens eine zweite gedruckte oder beschichtete funktionale Schicht. Die Funktionalitäten der Schichten werden entweder durch zwei unterschiedliche Materialien gebildet oder die gedruckten und gegebenenfalls bestäubten Schichten unterscheiden sich derart im Grad der Funktionalität, dass sie nicht in einem Druck- und ggf. Bestäubungsvorgang innerhalb eines Druckdurchganges erzeugt werden können.

## Beschreibung

Die Erfindung betrifft ein Verfahren zur Herstellung einer drucktechnisch erzeugten funktionalen Schicht nach dem Oberbegriff von Patentanspruch 1 ein Verfahren zur Herstellung von Multilayeranordnungen nach dem Oberbegriff von Anspruch 2 und eine Multilayeranordnung nach Anspruch 11.

Die beschriebenen Verfahren dienen zum teilweisen oder vollständigen drucktechnischen Herstellen funktionaler Komponenten, wie gedruckte Schaltungen, Transistoren, Datenspeicher, Sensoren, Displays, Batterien, Brennstoffzellen oder Solarzellen.

Die Anwendungen von Drucktechniken zur Herstellung von elektronischen Komponenten ist ein in der Fachwelt weithin diskutiertes und auch teilweise angewandtes Verfahren zum Herstellen von elektronischen funktionalen Komponenten. Drucktechniken, wie der Flexo-, der Tief- oder Offsetdruck, in besonderen Anwendungsbereichen auch der Tintenstrahldruck, zeichnen sich durch eine kostengünstige Fertigungsweise und eine sehr hohe Produktivität aus. Drucktechniken eignen sich daher einerseits für die Herstellung von Low-Cost-Elektronik, zum Beispiel für die Anwendung im Marketing (z.B. eine blinkende Leuchte an einer Verpackung, die auf Tastendruck reagiert), für die Herstellung von Sensoren (z.B. Blutzuckerindikatoren), aber auch für großflächige und hochvolumige Anwendungen. Ein Beispiel für hochvolumige Anwendungen, bei denen Drucktechniken zur Anwendung kommen, sind zum Beispiel Antennen für RFID-(radio-frequency-identification). Als Beispiel für großflächige Anwendungen sind Displays und Solarzellen.

Für den Druck der elektrischen und sensorischen Funktionalitäten werden weithin spezielle Druckfarben eingesetzt, die sich in der Regel aus einem Bindemittel und dem funktional wirksamen Stoff zusammensetzen. Die unterschiedlichen Druckfarben stellen dabei unterschiedlichste Anforderungen an die Druckfarben. Die Druckfarben für den Offsetdruck sind zum Beispiel hochpastös und müssen definierte rheologische Eigenschaften erfüllen. Die dynamische Viskosität für Offsetdruckfarben beträgt dabei 40 - 100 Pas. Außerdem ist die Bandbreite der verfügbaren Bindemittel beschränkt, die im Offsetdruck zur Anwendung kommen können. Im Falle des Nassoffsetdrucks kommt das Feuchtmittel als zusätzliche Prozessvariable hinzu, das nicht mit allen funktionalen Komponenten kompatibel ist. Andererseits zeichnet sich der Offsetdruck durch eine hohe Detailfeinheit aus, da gedruckte Strukturen ≤ 20 pm herstellbar sind. Dadurch ist dieses Verfahren geradezu für den Einsatz gedruckter elektronischer Funktionalitäten prädestiniert, wenn hohe Auflösungen bei geringer Schichtdicke von z.B. 1 - 2 µm Schichtauftrag gefordert sind.
Eine für den Offsetdruck geeignete Druckfarbe mit elektrischer Leitfähigkeit, wobei als funktionale Elemente für die Herstellung der Druckfarbe Silber beigefügt ist, ist unter anderem in der WO 97/48257 offenbart. Beschrieben ist ein Herstellungsverfahren, bei der eine Schaltung auf Papier, Karton oder synthetisches Papier mit einer Druckfarbe gedruckt wird, die elektrisch leitfähige Partikel enthält, die in einem Bindemittel suspendiert sind. Es wird ein Herstellungsverfahren für elektrische Widerstände, Kondensatoren und Antennen beschrieben.

Praktische Anwendungen solcher Druckfarben sind unter anderem in den Dokumenten WO 2005/086087 und WO 2005/013189 offenbart.

Im Flexodruck wird eine flüssige Druckfarbe eingesetzt, die eine Viskosität zwischen 0,05 und 0,5 Pas aufweist. Der Flexodruck kann eine große Bandbreite von Lösemitteln einsetzten, soweit die Kompatibilität mit den Druckmaterialien, zum Beispiel den Flexodruckplatten, gegeben ist. Die flüssige Druckfarbe stellt aber hohe Anforderungen an die Dispergierung der funktionalen Elemente, da diese sich nicht absetzen oder verklumpen dürfen. Daher ist die Menge der funktionalen Elemente, die in dem Lösemittel dispergiert werden können, limitiert. Auch können mit dem Flexodruck auf der Druckplatte hohe Auflösungen dargestellt werden. Drucktechnisch lassen sich aufgrund von Quetschrändern allerdings diese sich nicht wiedergeben, so dass die drucktechnisch dargestellte Detailgröße oftmals ≥ 50µm je nach Farbtyp liegt. Auch erfordert der Flexodruck eine gute Abstimmung zwischen Druckfarbe und Substrat, da ansonst es zu partiellen Perl- und Abstossungserscheinungen in der Druckfläche kommen kann, die die Funktionalität des gedruckten Produktes massiv einschränken kann.
Eine elektrisch funktionale Druckfarbe, die geeignet für den Flexodruck ist unter anderem in der WO 03/068874 offenbart. Als funktionale Elemente sind dort metallische Partikel, wie Silberpartikel, Kupferpartikel, Bronzepartikel, auch in Flakeform und deren Kombinationen beschrieben. Als weitere funktionale Partikel werden leitfähige Russe, Metalloxide, metallisch beschichtete Trägermaterialien, Antimon-Zinnoxid und Indium-Zinnoxide beschrieben.
Eine weitere Ausprägung einer leitfähigen, wässrigen Druckfarbe, die für den Einsatz im Flexodruck geeignet ist, ist in der EP 0 676 082 B1 offenbart. Die erfindungsgemäße wässrige Formulierung enthält als funktionale Partikel metallische Partikel, vorzugsweise Silberpartikel.
Praktische Anwendungen solcher Druckfarben sind unter anderem in den Patentoffenlegungsschriften WO 2005/086087 und WO 2005/013189 offenbart.

Im Tintenstrahldruck müssen andere rheologische Eigenschaften der Druckfarbe erfüllt werden, die eine definierte Tropfenbildung ohne Satellitenbildung ermöglichen. Dies limitiert einerseits die Auswahl der Lösemittel und deren Eigenschaften, aber auch die Größe der dispergierbaren funktionalen Elemente. Bei partikulären Systemen werden hierbei oft nanoskalige Systeme eingesetzt, die sehr teuer sind. Aber auch an nicht partikuläre Systeme, wie gelöste leitfähige Polymere, werden hohe Ansprüche gestellt.

Bei einer funktionalen Druckfarbe und einem Lack muss daher immer ein Kompromiss gefunden werden zwischen den für das jeweilige Druckverfahren benötigten Binde- und Lösemitteleigenschaften, den verarbeitungstechnischen Anforderungen des Druckverfahrens und den funktionalen Anforderungen an die Beschichtung. Hier müssen immer Kompromisse gesucht werden, die im Regelfall die Performance des Gesamtsystems nach der einen oder anderen Seite verschlechtert. Ein wesentlicher Teil der Forschung in der gedruckten Elektronik ist daher darauf fixiert die Verarbeitbarkeit der funktionalen Elemente zu verbessern. Bis jetzt gibt es aber keine ideale Druckverfahren / Druckfarbenkombination im Bereich des funktionalen Druckens, die alle Anforderungen erfüllt.

Schon frühzeitig wurde in der Industrie erkannt, dass das Hochgeschwindigkeitsdrucken von aktiven oder passiven Komponenten ein hohes Rationalisierungspotential bietet. Die US 3,484,654 offenbarte schon 1967 ein Herstellungsverfahren bei denen aktive und passive elektronische Bauelemente durch den Druck von leitfähigen, dieelektrischen und halbleitenden Druckfarben erzeugt werden. Als Druckverfahren werden die Massendruckverfahren Flexodruck, Letterpress und Tiefdruck beispielhaft erwähnt. Zwischen den einzelnen Druckabschnitten können Trocknungsschritte der Druckfarbenschichten erfolgen, wobei die Trocknung entweder durch Evaporation oder durch Härtung (Polymerisation) bei Epoxy-Schichten geschieht. Als Beispiel für drucktechnisch hergestellte Bauelemente werden Kondensatoren und ein Widerstands-Kondensatoren Netzwerke aufgeführt.

Die WO 96/40522 offenbart den Druck von elektrischen Schaltkreisen mit einer leitfähigen Druckverfahren, wonach erfindungsgemäß ebenfalls die Massendruckverfahren eine leitfähige Druckschicht aufgetragen werden. Als Druckverfahren werden Tiefdruck, Flexodruck, Offset Tiefdruck, Offset und Letterpress erwähnt. Der Druck von leitfähigen Schichten kann mit dem Druck von Spezialfarben kombiniert werden. Als Spezialfarben werden Druckfarben für thermochrome Effekte, elektrophosphoreszierende Druckfarben, magnetische Druckfarben, elektrochrome Druckfarben, elektroluminiszierende Druckfarben und der Druck von Elektrolyten offenbart. Der Druck kann durch die Applikation einer Schutzfolienkaschierung oder Laminierung ergänzt werden. Als in diesem Verfahren hergestellte Produkte werden elektrische Schaltungen, Medikamentenspender, die die Medikamentenentnahme kontrollieren, elektrische Schalter, Kondensatoren, Energiequellen (Batterien), Widerstände, Leuchtanzeigen, Tags für den Diebstahlschutz, Heizelemente, Kühlelemente, als Sicherheitselement für Dokumente, Aufdruck für Mikrowellenverpackungen und Displays erwähnt. Das Dokument umfasst somit schon eine Vielzahl drucktechnisch herstellbarer Produkte, die mit leitfähigen Druckfarben und Spezialfarben hergestellt werden können.

Die WO 2005/021276 offenbart den Druck von elektrischen Funktionalitäten mit dem Farbendruck, die gegebenenfalls in der Druckmaschine mit diskreten elektrischen oder elektronischen Bausteinen während des Drucklaufs verbunden werden. Außerdem offenbart sie Verfahren zur Herstellung gedruckter Transistoren, bei dem halbleitfähige Materialien, isolierende Materialien und leitfähige Materialien derart auf den Bedruckstoff gedruckt werden, dass Transistoren und aus Transistoren zusammengefügte Halbleiterchips bereitgestellt werden.

In alle diesen Anwendungen werden die leitfähigen, halbleitfähigen und isolierenden Materialien durch das Aufbringen von Druckfarbe mit den gewünschten elektrischen Eigenschaften erzeugt. Auch andere Spezialeffekte, wie zum Beispiel Luminiszenz, werden durch das Aufbringen von entsprechenden Druckfarben erzeugt. Dies bedeutet, dass die funktionalen Elemente in eine Bindemittel und/oder Lösemittelmatrix eingebracht werden müssen, wodurch die Funktionalität sich nicht in optimaler Weise ausbilden kann. Außerdem schränken die funktionalen Elemente und die damit verbundene gewünschte Funktionalität die Designfreiheit bei der Druckfarbenherstellung ein, d.h. eine Druckfarbe kann in der Regel nicht auf maximale Druckauflösung und Kantenschärfe getrimmt werden.

Ein Einsatz dieses Dilemma zu umgehen ist den Vorgang der Strukturierung durch das Druckverfahren von der Erzeugung der gewünschten Funktion zu trennen.

Dies kann geschehen, indem eine klebrige Farbe oder ein Kleber in einem Druckverfahren, wie zum Beispiel Offset, Tiefdruck oder Flexodruck gedruckt wird und anschließend mit dem funktionalen Element bestäubt wird.

Die Idee das Strukturieren durch den Druckvorgang von der Aufbringung der eigentlichen Funktionalität zu trennen ist nicht neu und in der Patentliteratur umfassend beschrieben.

So ist aus den DE-OS 1 075 179 und der US 2 963 748 ein Verfahren zur Herstellung von Leiterplatten bekannt, bei dem Trägermaterialien ganzflächig mit einem Klebstoff beschichtet wird, anschließend Metallpulver darauf zu verstreut und dann mit einem Stempel, dessen Stempelflächen in der Form der Leiteranordnung ausgestaltet sind, diejenigen Schichtteile, die als Leiterbahnen stehen bleiben sollen, einem solchen Druck zu unterwerfen, dass an diesen Stellen das Metallpulver kalt zusammengeschweißt wird. Der Nachteil dieses Verfahrens sind die hohen Stempelkosten. Außerdem lässt sich das überschüssige, nicht kalt zusammengeschweißte, Material nur schwer entfernen, da dieses in Kontakt mit dem Klebstoff steht.

Es ist auch ein Verfahren zur Herstellung leitfähiger Strukturen aus der DE 11 47 640 bekannt, bei dem Klebstoff in Form eines Leitungsbildes auf das Trägermaterial aufgebracht wird, das Leiterbild anschließend mit Metallpulver bestreut wird, dessen nicht an dem vorgedruckten Klebstoff anhaftenden Körner anschließend wieder entfernt werden. Die Körner, die mit der gedruckten Kleberstruktur verhaftet sind, werden unter leichtem Druck verdichtet und anschließend wird in einer chemischen Reduktionsreaktion auf der Metallpulverschicht eine Metallschicht abgelagert. Das Metallpulver wird dabei in einem elektrostatischen Feld abgelagert, eine Bestäubung durch Elektrostatik ist folglich bekannt. Als vorteilhaft gegenüber dem reinen Bestäuben einer Kleberschicht wird für das elektrostatische Bestäuben angeführt, dass die Partikel weitgehend ausgerichtet werden und nicht mehr wahllos auf das Substrat fallen. Dadurch gelangen pro Flächeneinheit mehr Teilchen auf den Kleber, so dass eine größere Homogenität im Leiterzug erzielt wird. Ferner erfolgt durch die Beschleunigung der Teilchen im elektrostatischen Feld eine innige Verbindung mit dem Kleber. Dadurch wird verhindert, dass bei dem Entfernen derjenigen Pulver-Teilchen, die sich auf den nicht klebenden Flächen der Platte befinden, in unerwünschter Weise auch Teilchen von den klebenden Stellen entfernt werden. Die nicht haftenden Pulverteilchen werden von dem Substrat weggeblasen und der Kleber durch den Kontakt mit einer beheizten Platte gehärtet, wobei gleichzeitig die Metallteilchen verdichtet werden. Die Leiterbahn kann anschließend durch Tauchlöten verstärkt werden. Die Patentschrift offenbart ausdrücklich den Druck von Klebern im Offsetverfahren. Eine konkrete Ausführungsform lässt das Patent jedoch offen.

Die DE 11 07 743 beschreibt ein Verfahren zur Herstellung gedruckter Schaltungen, wobei das Leitungsbild mittels des Siebdruckverfahrens auf Isolierplatten aufgedruckten Klebers gebildet wird, anschließend in einem weiteren Arbeitsschritt ein Metallpulver aufgebracht wird und dieses dann mit einer Lotschicht versehen wird, wobei zuerst eine Harzkomponente des Klebers zuerst in Form eines Leitungsbildes aufgedruckt wird und der Härter dann anschließend getrennt davon aufgebracht wird. Die aufgebrachte Metallschicht wird durch das Tauchlötverfahren verstärkt.

Die EP 0 003 363 B1 beschreibt ein Verfahren zur Herstellung leitfähiger Strukturen, wobei das Trägermaterial mit einem elektrisch isolierenden Material beschichtet ist und diese Schicht mittels bildgemäßer Belichtung eines photoadhäsiven Klebstoffes in haftende und nicht haftende Bereiche strukturiert wird. Anschließend werden Metallteilchen auf die Schicht aufgebracht, wobei die Metallteilchen auf den haftfähigen Bereichen haften und die überschüssigen Metallteilchen entfernt werden. Anschließend wird eine beschränkte Scherung auf die Metallteilchen ausgeübt, so dass diese Metallteilchen zusammengefügt werden und eine beschädigungsfreie Schaltungsspur bilden.

In der Patentschrift US 833,000 wird eine Weiterentwicklung des Bestäubungsverfahrens beschrieben, bei dem eine klebrige Schicht, die zum Beispiel im Offset oder im Siebdruck auf ein Substrat aufgetragen wurde, mit Metallpulver bestäubt wird, und anschließend die klebrige Schicht gehärtet wird. Das Metallpulver ist vorzugsweise dabei Silber- oder Zinnbeschichtet, um eine Korrosion des Metallpulvers zu vermeiden. Die Metallschicht muss dabei nicht zwingend selber leitend sein, sondern dient als Seedlayer für die Abscheidung weitere metallsicher Schichten, so dass in der Regel erst nach dem Abscheidungsprozess die volle elektrische Leitfähigkeit zur Verfügung steht. Dieses Verfahren hat den Vorteil, dass die Anforderungen an die Verdichtung und die Verteilung der metallischen Stäube nicht sehr hoch ist im Vergleich zu den Bestäubungsverfahren, bei denen die bestäubten Klebespuren auch die elektrische Leitfähigkeit sicher stellen müssen.

Die EP 0 414 363 B1 beschreibt ein Verfahren zur Herstellung elektrisch leitfähiger Leitungszüge. Das Leitungszugmuster wird im Inkjet auf das Substrat aufgedruckt und die gedruckte Struktur anschließend mit einem Metallpuder bestäubt, wobei das Metall anschließend geschmolzen wird. Die Inkjet-Tinte umfasst dabei 4 bis 40% des Druckfarbenvolumens ein Haftmittel. Vor dem Schmelzen des aufgestäubten Metalls werden überflüssige Partikel entfernt.

Die EP 04 13 335 A2 offenbart ein Verfahren zur Montage elektrischer diskreter Bauelemente, wobei Leitkleber auf Kontaktflächen aufgetragen wird und dabei elektrisch leitfähige Partikel mittels elektrostatischen Feldern zwischen einem Substrat und einer Entladungselektrode abgeschieden werden, wobei die Partikel zuvor in einem Korona-Feld aufgeladen wurden.

Die DE 10 2005 038 956 B3 zeigt ein Verfahren zur Beschichtung einer Struktur, die mindestens einen Halbleiterchip aufweist. Dabei wird ein elektrostatisches Abscheiden von Beschichtungspartikeln auf den zu beschichtenden Flächen der Struktur angewandt. Dazu werden erst Beschichtungspartikel auf einen Träger aufgebracht und dieser elektrostatisch mit den Beschichtungspartikeln aufgeladen. Die Struktur mit mindestens einem Halbleiterchip wird entgegengesetzt elektrostatisch aufgeladen. Danach wird der Träger und / oder die Struktur in Richtung der zu beschichteten Fläche der Struktur aufeinander zu bewegt, bis die Beschichtungspartikel auf die zu beschichteten Flächen der Struktur überspringen und dort haften bleiben.

Die WO 2005/101930 beschreibt ein Verfahren, bei der in einem Offsetdruckwerk ein Kleber bildgemäß auf ein Träger aufgedruckt wird und das Trägermaterial dann in einem nachfolgenden Arbeitsschritt mit einer Folie in Kontakt gebracht wird, die mit einem leitfähigen Material beschichtet ist. Dieses auf der Folie befindliche leitfähige Material haftet an dem auf dem Trägermaterial bildgemäß aufgebrachten Kleber und wird von der Trägerfolie abgelöst. Das übertragene Material bildet dabei die Leiterbahn. In einer Weiterbildung wird zusätzlich ein Verfahren beschrieben, indem ein leitfähiges Material über eine Zylinder auf das Trägermaterial übertragen wird und nur an den Stellen anhaftet, die mit dem Kleber vorab bedruckt wurden. Die Trägerfolie kann auch für den Transfer isolierender Schichten genutzt werden.

Die DE 10 2005 019 920 beschreibt ein Verfahren zur Herstellung leitfähiger Strukturen, bei dem auf einer Trommel in digitaler Form ein latentes magnetisches Bild der elektrisch leitfähigen Struktur erzeugt wird und anschließend mittels der Druckform magnetische Partikel mittels der partiell magnetisierten Druckform angezogen werden und von dort auf das Drucksubstrat übertragen und auf diesem fixiert werden. Nachteilig an diesem Verfahren ist, dass nur magnetisierbare Partikel auf den Bedruckstoff übertragen werden können. Daher hat dieses Verfahren nur einen beschränkten Anwendungsbereich. Die in dem Patent erwähnten funktionalen Partikel mit Eisenkern sind in vielen Anwendungen unerwünscht.

Auch in anderen Anwendungsbereichen der Druckverfahren werden pulvrige Partikel zur Erzeugung von Funktionalitäten eingesetzt. Die GB 2 056 885 zeigt eine Bestäubung von Substraten, wie zum Beispiel Papier und Karton, die nach dem Auftrag durch Hitze gehärtet werden. Für den Auftrag der Puderpartikel auf das Substrat werden Pudersprühdüsen verwendet.

Die Patentoffenlegungsschrift DE 26 46 798 beschreibt eine Vorrichtung zur elektrischen Aufladungen von flüssigen oder festen Teilchen zum Aufbringen auf Oberflächen. Im Stand der Technik der besagten Patentoffenlegungsschrift wird die Kontaktaufladung angeführt, wobei die Teilchen durch Berührung mit elektrisch leitenden Flächen Ladung aufnehmen. Als Nachteil für die Kontaktaufladung wird angeführt, dass der eigentlich laminar gewünschte Luftstrom turbulent gemacht werden muss, dass möglichst viele Teilchen mit der leitenden Fläche in Kontakt kommen muss. Insbesondere bei kleinen Teilchen wird der Wirkungsgrad der Kontaktaufladung als nicht effizient bezeichnet. Ferner wird im Stand der Technik die Reibungsaufladung beschrieben. Diese wird aber als unzuverlässig beschrieben, da die Polarität der Teilchen sich mit dem Klima (Temperatur und Feuchtigkeit) wechseln kann, so dass keine reproduzierbaren Ergebnisse erzielt werden können. Auch eine elektrische Aufladung durch thermoionische Emission oder durch Elektronenstrahlen ist bekannt, wegen des hohen apparativen Aufwands aber praktisch nicht einsetzbar. Deshalb schlagen die Erfinder vor, dass in einem von den Teilchen und Gas durchströmten Raum in Strömungsrichtung hintereinander wenigstens eine erste und eine zweite metallische Elektrode angeordnet sind, von denen die erste Elektrode mit Hochspannung einer bestimmten Polarität und die zweite Elektrode mit der entgegengesetzten Polarität gespeist ist, und dass der an den Elektroden durch Coronaentladung elektrisch geladene Teilchen enthaltende Gasstrom aus dem Raum auf die Oberfläche auftrifft. Die Oberflächen auf die die geladenen Teilchen appliziert werden können dabei eine Ladung tragen, die der Ladung der Teilchen entgegengesetzt sind. Die Oberfläche kann aber auch geerdet sein. Als Anwendung wird in der Patentoffenlegungsschrift die Applikation von Teilchen auf Papieroberflächen explizit erwähnt. Als Argument für diese Art der Applikation wird angeführt, dass die Teilchen gezielt auf die Oberfläche geführt werden und daher weniger Verluste und Umweltbelastungen auftreten.

Auch in der Bestäubung von Druckprodukten mit Puder, das als Abstandshalter zwischen den einzelnen Papierlagen in einem Papierstapel, bestehend aus frisch bedruckten Papierlagen, eingesetzt wird, um eine Ablegen oder Markieren der Druckbogen zu Vermeiden, werden elektrostatische Bestäubungsverfahren eingesetzt. Die DE 44 27 904 A1 beschreibt ein Bestäubungsgerät bei dem Puder elektrostatisch aufgeladen wird, bevor dieser auf einen bedruckten Papierbogen aufgeblasen wird. Die DE 29 36 754 zeigt ein Bestäubungsverfahren, bei dem in der Nähe des Papierbogen ein elektrisches Feld erzeugt wird, indem das Puder eingeblasen wird. Aufgrund der Ausbildung der Feldlinien wird der Puder auf das Substrat gelenkt. In der DE 31 35 220 wird ein Verfahren zum Bestäuben von Druckbogen aufgezeigt, bei dem der Druckbogen auf unbedruckten, gegenüberliegenden Seite aufgeladen wird, um die Bestäubung zu verbessern. Die EP 1 105 295 B1 zeigt eine weitere Ausführungsform zum elektrostatischen Bepudern von frisch gedruckten Papierbögen. Die Bepuderung erfolgt dabei flächig und in so geringen Mengen, dass außer der Funktion Abstandshalter keine weiteren Funktionalitäten erzielt werden können.

Die WO 97/36049 beschreibt ein Verfahren zur Lackierung von Karton- und Papiersubstraten. Die Erfindung ist charakterisiert dadurch, dass Puderpartikel zuerst durch Friktion oder Induktion aufgeladen werden, und dann direkt oder über ein Transfermedium auf das Substrat übertragen werden. Die Übertragung erfolgt in einem elektrischen Feld zwischen dem Substrat und dem Übertragungsmedium. Die Puderpartikel werden dann durch Elektronenstrahlhärtung oder UV-Härtung gehärtet. Abhängig von der Leitfähigkeit des Substrates wird das elektrische Feld durch eine Koronaaufladung oder eine bewegliche oder fixe Gegenelektrode. In dem Fall, dass die Puderpartikel über ein Transfermedium auf das Substrat übertragen wird, werden die Puderpartikel zuerst auf das Transfermedium mittels des elektrischen Feldes appliziert und dann von dem Transfermedium auf das Substrat übertragen. Die Übertragung der Puderpartikel kann dabei durch elektrische, elektrostatische oder mechanische Kräfte erfolgen. Die Übertragung der Puderpartikel kann dabei vollflächig oder bildhaft / partiell erfolgen. Bei der bildhaften Übertragung wird das Transfermedium bildhaft mit bekannten Methoden, wie sie aus den elektrostatischen Druckverfahren bekannt sind, belichtet.

Die WO 03/076715 beschreibt einen trockenen Prozess zur Oberflächenveredelung eines Substrates, wie zum Beispiel Papier, Karton, Folie oder metallische Substrate, der einen trockenen Puderauftrag umfasst, gefolgt von einem Fixierungsschritt. Für den Auftrag des Puders wird ein elektrisches Feld genutzt, um die Puderpartikel auf das Substrat zu transportieren, wobei die elektrostatische Aufladung auch für eine Fixierung der Partikel auf dem Substrat sorgt. Die endgültige Fixierung der Partikel und die Glättung des Puderauftrags erfolgt dabei gleichzeitig in einem Arbeitsschritt durch ein thermomechanische oder andere geeignete Behandlung. In dem trockenen Puderbeschichtungsprozess ein elektrisches Feld wird zwischen zwei Elektroden erzeugt, welche ein unterschiedliches Potential haben. Das Substrat, das beschichtet werden soll, befindet zwischen den Elektroden. Bei mindestens einer Elektrode handelt es sich um eine Corona Elektrode, die das umgebende Gas auflädt. Die aufgeladenen Gasatome, Moleküle oder Molekülgruppen lagern sich an der Oberfläche der Puderpartikel an und bringen somit eine Ladung auf die Partikel. Die Besonderheit dieser Patentschrift ist, dass die Partikel vorgeladen werden, bevor sie in das elektrische Feld eingebracht werden. Das Ziel der Vorladung ist es eine längere Aufladungszeit zu erhalten als dies bei einem einzelnen Ladungsschritt möglich wäre. Die Partikel können dabei aktiv aufgeladen werden, zum Beispiel durch eine Corona-Anlage, oder aber auch durch tribo-elektrische Aufladung. Die tribo-elektrische Aufladung kann durch die Reibung der Puderpartikel untereinander, durch die Reibung der Puderpartikel an den Wänden des Vorratsbehälters oder der Transportrohre geschehen.
Die Beschichtung von Substraten mit elektrostatischen Druck- oder Beschichtungsverfahren ist aus der Patent- und Fachliteratur auch bestens bekannt.

Die EP 1 479 453 B1 beschreibt ein Verfahren zum elektrostatischen Beschichten von Kunststoffsubstraten, wobei das Kunststoffsubstrat zuerst mit einem wässrigen Primer beschichtet wird, der anschließend angetrocknet wird, beschichtet diese Schicht dann mit einer weiteren Schicht, wobei die Beschichtung in einem elektrostatischen Verfahren erfolgt.

Die WO 92/22912 beschreibt unter anderem ein Verfahren zur Erhöhung der O-berflächenleitfähigkeit eines Substrates, wobei eine Beschichtung auch elektrostatisch aufgetragen werden kann. Die Beschichtung erfolgt dabei flächig und nicht strukturiert und auch die verwendeten Materialien sind nicht für die Ausbildung von funktionellen Strukturen geeignet. Die leitfähige Beschichtung dient vielmehr nur dazu, elektrostatische Aufladungen wegzuführen.

Die US 3,140,199 beschreibt eine Verfahren für ein elektrostatisches Drucken, wobei ein latentes, elektrostatische geladenes Bild auf dem Substrat auf der photo-leitfähigen Schicht auf einem Substrat erzeugt wird durch das Aufladen der Schicht und einem anschließenden Belichtungsschritt. Tonerpartikel, die auf einem beweglichen Band durch tribo-elektrische Aufladung aufgeladen werden auf dieses transferiert werden. Das Ablösen der Partikel von dem Band erfolgt unter anderem durch mechanische Vibration.

Die US 3,653,758 beschreibt ein druck- und kontaktloses Verfahren zum elektrostatischen Drucken, wobei auf einer Platte die Tonerpartikel bildgemäß fixiert werden, diese Platte dann mit den Tonerpartikeln in den Transferspalt zum Substrat bewegt wird, wobei die Platte dann Ultraschallschwingungen ausgesetzt wird, die das Ablösen der Tonerpartikel fördert und die Tonerpartikel dann in einem elektrostatischen Feld auf das Substrat übertragen werden.

Die DE 1 546 739 beschreibt ein Verfahren zum elektrostatischen Bedrucken einer Unterlage. Die Druckvorrichtung zeichnet sich aus, dass in dem Raum zwischen der Unterlage und der Basiselektrode ein Siebgitter angeordnet ist und mittels einer Hochspannungsquelle ein elektrostatisches Feld erzeugt wird, um Pigmente, die aus einem Vorrat in das elektrostatische Feld überführt werden, zu beschleunigen und auf der Unterlage niederzuschlagen. Die Basiselektrode ist dabei als Endlosbandförderer ausgebildet.

Die EP 0 978 769 und EP 0 809 158 offenbaren ein direktes elektrostatisches Druckverfahren, bei dem geladene Tonerpartikel auf ein nicht magnetisches Druckband oder einen Zwischenträger gebracht werden, ein elektrisches Feld zwischen dem die geladenen Tonerpartikel tragenden Zwischenträger und dem Empfängersubstrat angelegt wird, um einen Fluss von Partikeln auf das Substrat zu erzeugen, der durch einen Druckkopf kontrolliert wird, der Öffnungen aufweist, durch die der Toner auf das Substrat aufgetragen wird, wobei der Druckkopf Kontrollelektroden aufweist, durch die der Tonerfluss kontrolliert werden kann.

Die EP 0 763 785 beschreibt eine Abwandlung der obigen direkten elektrostatischen Druckverfahren, wobei eine die Vorrichtung eine Druckkopfstruktur aufweist, die eine Matrix von Drucköffnungen hat, durch die ein Teilchenstrom über eine Steuerelektrode elektrisch moduliert werden kann, und einen Zwischenträger, der die geladenen Tonerteilchen in die Nähe der Drucköffnungen transportiert, wobei die geladenen Tonerteilchen in der Nähe der Drucköffnung durch einen Gasstrom derart von dem Zwischenträger abgelöst werden, dass die Teilchen in der Nähe der Drucköffnung eine Teilchenwolke bilden.

Die US 7,149,460 B2 beschreibt ein gut geeignetes Verfahren zum Aufladen von Partikeln für die Anwendung in elektrostatischen Druckverfahren.

Die Ausbildung aktiver Elemente oder passiver Elemente, die Bestandteil eines aktiven Elements sind, werden nicht beschrieben. Einzig die DE 10 2005 018 920 und die WO 2005/101930 beschreiben ein Verfahren zum Drucken von Antennen für RFID-Anwendungen durch den Auftrag einer funktionalen, leitfähigen Schicht erwähnt.

Der Begriff "funktionale Schichten", "funktionale Partikel" oder "funktionale Druckfarben" bezieht sich auf funktionales Material und dessen Verwendung, wobei das funktionale Material mindestens eine Eigenschaft hat, die nicht dekorativ ist. Ungeachtet dessen können funktionale Materialien auch dekorative Eigenschaften haben. Die funktionale Eigenschaft des Materials kann inhärent sein, oder durch eine Behandlung des Materials erzielt werden. Die funktionale Eigenschaften können dabei durch physikalische und / oder chemische Manipulationen des Materials, oder durch Wechselwirkungen entlang und mit dem Substrat oder anderen Materialien erzielt werden.

Verdruckbare funktionale Schichten können zur Sicherstellung der Funktion elektrische Leitfähigkeit metallische Partikel in verschiedenen Zusammensetzungen beinhalten. Die Metallischen Partikel können dabei Kupfer, Silber, Gold, Palladium, Platin, Nickel, Aluminium, Cadmium, Iridium, Ruthenium, Osmium, Platin, Kobalt, Indium, Zinn, Zink, Antimon, Blei oder deren Legierungen sein. Im Prinzip können alle Partikel auf Basis von Metallen eingesetzt werden, die der Gruppe IV des Periodensystems angehören. Bei den Partikeln kann es sich auch um beschichtete metallische Partikel, zum Beispiel aus Kupfer bestehend, handeln, die aus Gründen der Korrosionsinhibierung mit Silber oder Zinn beschichtet sind. Die Partikelform kann dabei verschiedene Ausprägungen haben, wobei eine Mischung aus verschiedenen Partikelformen, wie zum Beispiel die Mischung von runden und stabförmigen Partikeln, erwiesenermaßen eine bessere Leitfähigkeit ergibt. Eine besondere Form der metallischen Partikel sind die so genannten Flakes, die flache metallische Partikel darstellen. Die flachen Partikel können entweder durch mechanische Bearbeitung hergestellt werden oder dadurch, dass eine metallische Schicht auf ein Trägermaterial aufgedampft wird und diese Schicht dann als Flake von dem Trägermaterial abgelöst wird.

Anwendungen solcher metallischen Partikel in Druckfarben sind unter anderem für Anwendungen im Tiefdruck in den Patentschriften WO 03/068874 und EP 0 452 118 B1 beschrieben. Anwendungen im Flexodruck sind in der WO 03/068874 ebenfalls offenbart. Anwendungen von elektrisch leitfähigen Druckfarben für den Offsetdruck zeigt die WO 97/48257. Anwendungen von Druckfarben mit nanopartikulären metallischen Metallpigmenten im Ink-Jet-Druck sind unter anderem aus der WO 2005/ 101427 bekannt. Anwendungen von Flakes aus elektrisch leitenden Material in Druckfarben sind in der WO 03/096384 beschrieben.

Die EP 0 961 809 B1 beschreibt eine Druckfarbe bestehend aus einem metallischen Partikel und einem reaktivem organischem Medium, das mit dem Metall reagieren kann unter Erzeugung einer metallorganischen Zersetzungsverbindung, wobei die Zusammensetzung auf ein Substrat aufgebracht wird und sich bei einer Temperatur von 450 Grad Celsius zu einem massiven elektrischen Leiter zersetzt.

Ein weiteres leitfähiges Pigment, das alleine als einziges funktionales Element oder in Kombination mit metallischen Partikeln eingesetzt wird, sind leitfähige Russe oder Graphit. Russ oder Graphit wird oftmals in Kombination mit metallischen Partikeln eingesetzt, wie die EP 0 676 082 B1 zeigt. Weitere Anwendungen von leitfähigem Russ oder Graphit sind in der WO 2005/012445 offenbart.

Eine weitere leitfähige Komponente, die in der Wissenschaft sehr viel diskutiert wird, sind Nanotubes (Kohlenstoffröhrchen). Diese Nanotubes können prinzipiell auch als leitfähige Komponente in Druckfarben eingesetzt werden, wie es die WO 2006/108165 beschreibt. Offenbart ist eine Druckfarbe für den Ink-Jet-Druck, die neben metallischen Partikeln auch Nanotubes enthält.

Eine besondere Ausführungsform leitfähiger Pigmente sind mit einem leitfähigen Material beschichtete Trägerplättchen. In der EP 0 375 575 werden leitfähige plättchenförmige Pigmente beschrieben, die aus einem plättchenförmigen Material, das mit einer Metalloxidschicht bedeckt ist, oder einem plättchenförmigen Metalloxide bestehen. Diese Plättchen werden mit einer leitfähigen Schicht aus Antimon dotierten Zinkoxide überzogen. Plättchenförmige Pigmente können dabei auf plättchenförmigen Trägermaterialien wie Glimmer, Kaolin, Talkum, Schichtsilikate oder Glasplättchen basieren, die mit einer leitfähigen Beschichtung versehen sind. Metalloxide für die Beschichtung können dabei Titanoxide, Zirkoniumoxide, Zinkoxide, Chromoxide, Nickeloxide, Kupferoxide, Kobaltoxide, Eisenoxide oder Mischungen dieser Metalloxide sein.

Die EP 0079 845 B1 beschreibt eine Verfahren zum Herstellen von Leiterplatten, bei dem strukturiert eine Masse oder Farbe aufgetragen wird, die anschließend eingebrannt wird, wobei eine isolierende Masse verwendet wird, die ein nicht leitendes Metalloxid eines nicht-edlen Metalls enthält, das Aufgrund der Zusammensetzung leitend oder nicht leitend sein kann und diese aufgetragene Schicht anschließend zu einem leitenden Metall durch Verwendung eines Reduktionsmittels überführt wird. Die Schichten können dabei erfindungsgemäß im Siebdruckverfahren aufgetragen werden.

Die WO 2006 / 018213 beschreibt eine weitere und neue Form von elektrisch leitenden Pigmenten, wobei die Pigmente einen ferromagnetischen Kern, zum Beispiel aus Eisen, und wenigstens eine elektrisch leitfähige Beschichtung aufweisen. Die elektrisch leitfähige Beschichtung kann dabei aus einem Metall, aber auch aus leitfähigen Polymeren oder Kunststoffen bestehen. Die elektrisch leitfähigen Pigmente werden dabei aus der Gruppe ausgewählt, die aus Polypyrrol, Polythiophen, Polyphenylen, Polyanilin, Polyacetylen und deren Mischungen besteht.

Die Pigmente können aber auch nadel- oder faserförmige Trägermaterialien sein, die mit einer leitfähigen Beschichtung überzogen sein. Solche Trägermaterialien können zum Beispiel Glasfasern, Aluminiumoxidfasern oder Titanoxidfasern sein. Die Anwendung solcher nadel- oder faserförmigen leitfähig beschichteten Trägermaterialien wird in der DE 42 37 990 unter anderem aufgezeigt. Prinzipiell lassen sich auch Kohlenstofffasern als leitfähige Komponente einsetzen, die aber nicht zwingend noch einmal beschichtet werden müssen, da sie an sich schon leitfähig sind.

Prinzipiell ist es auch möglich leitfähige Strukturen zu erzielen, indem eine Druckfarbe, die ein nicht- oder leitfähiges auf ein Substrat enthält, auf ein Substrat aufgedruckt wird und anschließend das Metalloxide in einem Reduktionsschritt zu Metall reduziert wird. Die US 4 756 756 umfasst einen Siebdruckprozess mit dem eine Druckfarbe mit einem nicht leitenden Metalloxid auf ein isolierendes Material gedruckt wird, gefolgt von einem Arbeitsschritt, bei dem ein Reduktionsmittel aufgetragen wird, wobei das Metalloxide zu einem leitenden Metall reduziert wird. Die US 3,873,360 bezieht sich auf einen Herstellungsprozess für eine leitfähige Schicht, bei welcher Metallionen in Lösung auf ein Substrat beschichtet werden und dann ein Muster mit einem Reduktionsmittel aufgedruckt wird.

Die WO 03/009659 beschreibt eine Offsetdruckfarbe, die Metalloxide enthält, wobei die Druckfarbe auch eine Reduktionsmittel enthält oder die gedruckte Schicht nachträglich durch das Auftragen eines Reduktionsmittels die in der Druckfarbe enthaltenen Metalloxiden zu Metall reduziert werden. Die leitfähigen Strukturen können dabei nachträglich durch stromlose Abscheidung oder Galvanisierung durch den Auftrag weiterer Metallschichten verstärkt werden.

Die WO 2006/093398 A1 bezieht sich auf eine leitfähige Druckfarbe, die ein Metallkomplex beinhaltet, das aus der Reaktion eines Metalls oder einer Metallverbindung entsteht.

Eine neue Klasse von leitfähigen Materialien stellen elektrisch leitende oder halbleitende Polymere dar. Die leitenden oder halbleitenden Polymere ermöglichen neue Herstellungsverfahren, die eine massenhafte Herstellung von Low-Cost-Elektronik erlaubt. Als leitfähige Polymere, die auch "intrinsisch leitfähige Polymere" bzw. "organische Metalle" genannt werden, bezeichnet man Stoffe, die aus niedermolekularen Verbindungen aufgebaut werden, wobei die Monomere zu einem Oligomer chemisch miteinander verknüpft sind und im neutralen, nicht leitfähigen, Zustand ein konjugiertes π-Elektronensystem aufweisen und durch Oxidation, Reduktion oder Dotierung in eine ionische Form übergeführt werden, die leitfähig ist. Die Dotierung kann durch Oxidation oder durch Reduktion erfolgen. Beispiele für intrinsisch leitfähige Polymere sind Polyanilin (PANI), Polythiophen (PTh), Poly (3,4-ethylendioxythiophen) (PEDT), Polythienothiophen (PTT),Polydiacetylen, Polyacetylen (PAc), Polypyrrol (PPy), Polyisothianaphthen (PITN), Polyheteroarylenvinylen (PArV), Poly-p-phenylen (PpP), Polyphenylensulfid (PPs), Polyperinaphtalin (PPn), Polypthalocyanin (PPc), und deren Derivate, um nur einige zu nennen. Klassische Drucktechniken können für die Applikation dieser Schichten angewandt werden. So wurden zum Beispiel in der Offsetdrucktechnik schon funktionsfähige Transistoren hergestellt, deren Funktionalität teilweise durch halbleitende Polymere gebildet wurde. Diese funktionalen Polymere können alleine als Druckfarben aufgetragen werden oder indem ein Trägermaterial mit diesen leitenden oder halbleitenden Materialien beschichtet wird, wie es zum Beispiel die WO 2006 / 018213 zeigt. Die WO 2000/16595 offenbart eine Druckverfahren zur Herstellung von Leiterbahnen unter Verwendung von Polyalkylene Dioxythiophene. Als Substrat werden explizit Papier und Kunststofffolie erwähnt.

Funktionale Bauelemente im Sinne dieser Erfindung können zum Beispiel vollständig oder teilweise gedruckte Transistoren sein. Eine bevorzugte Bauform eines Transistors, der drucktechnisch hergestellt werden kann, ist der Feldeffekttransistor. Die US 5,705,826 zeigt einen Aufbau von Feldeffekttransistoren (FET), die wenigstens teilweise organische Materialien enthalten, für die Ansteuerung eines Displays. Die Gate-Elektroden des FET können dabei Metallen, wie Gold, Platin, Chrom, Palladium, Indium, Molybdän, und ähnlichen Metallen bestehen, oder aus anorganischen Materialien, wie Polysilicon, amorphes Silicon, Zinnoxid, Indiumoxid, Indium-Zinnoxid (ITO), oder aus organischen Materialien, wie Polyanilin, Polythiophen, oder ähnlichen elektrisch leitfähigen organischen Materialien bestehen. Als Auftragsmethoden für die Gate-Elektroden auf das Substrat, zum Beispiel einen Kunststofffilm, sind Sputtern, galvanische oder stromlose Abscheidung und ähnliche Verfahren genannt, aber auch ausdrücklich Druckverfahren. Die halbleitende Schicht des FET wird durch konjugierte Polymere gebildet. Die halbleitende Schicht des FET kann erfindungsgemäß auch durch Druck- und Beschichtungsverfahren gebildet werden. Eine weitere gute Beschreibung eines FET ist in der DE 10 2004 022 603 A9 zu finden. Die US 5,705,826, die US 5,854,139, die US 2007/0066778 und US 2006/0255334 offenbaren weitere Ausführungen eines FET, der auf organischen leitenden oder halbleitenden Materialien beruht.

Ein Feldeffekttransitor wird dabei aus folgenden Komponenten gebildet: Einem Substrat, zum Beispiel Kunststofffolie, Papier, Karton, Keramik, Glass und anderen Materialien, und aus einem Halbleitermaterial, zum Beispiel aus einen leitfähigen Polymer, wie Polyanilin, Polypyrrole, Polyithiophene, Pentacene, oder aus organischen Halbleitermaterialien, wie Silizium, in dotierter oder nicht dotierter Form, und beliebiger Zusammensetzungen mit halbleitenden und leitenden Materialien, und aus einem isolierenden Material, und aus organischen oder anorganischen Leiterbahnen, die meist aus Metall gebildet werden.

Feldeffekttransistoren können in vielfältiger Weise eingesetzt werden. Zum Beispiel können diese als Ansteuerungselemente in Displays. Ein weiteres Anwendungsgebiet liegt in der Anwendung von preiswerten integrierten Schaltungen, wie sie zum Beispiel für die aktive Kennzeichnung und Identifizierung von Waren und Gütern zum Einsatz kommen. Der Einsatz von organischen Transistoren könnte den Einsatz von Transpondern gegenüber den klassischen Techniken deutlich günstiger machen.

Eine weitere Anwendung von funktionalen Materialien ist die Ausbildung von Sensoren und deren Verwendung in Prüfkörpern. Sensoren sind Schaltbilder, die in definierter Weise auf einen äußeren Einfluss reagieren. Die Reaktion kann sich zum Beispiel in einem elektrischen Impuls oder eine Farbänderung ausdrücken, die als Reaktion auf eine Veränderung von äußeren Einflüssen geschieht. Diese Einflüsse können Temperaturveränderungen, Lichteinfall, elektrische Stromleitung, Energie in jeder Form, aber auch eine Reaktion auf chemische oder biologische Stoffe oder biologische Spezies sein. Die EP 0987 333 beschreibt zum Beispiel verschiedene leitfähige Materialien, die in elektrochemischen Sensoren verwendet werden können. Die funktionalen, elektrisch leitfähigen Materialien bilden dabei eine Elektrode. Eine weitere Anwendung von Sensoren mit funktionalen Elementen zeigt die DE 10 2004 048 864. Der in diesem Dokument aufgezeigte Sensor, zum Bestimmen der Konzentration eines Analyten aus einer Körperflüssigkeit besteht aus einem analytischen Testelement und einem davon getrennten Instrument, wobei zu mindestens ein Teil der elektrischen Komponenten des Systems auf der Basis von Polymerelektronik ausgebildet ist. Auf dem Teststreifen befinden sich ein Teil mit Nachweischemie zum Nachweis eines Analyten, sowie ein Transponder zum Transfer von Daten zu einem Lesegerät. Die DE 102 53 154 beschreibt ein komplettes Blutglukose Messsystem, bestehend aus einer Messeinheit und Biosensor, wobei dieses in einem einzigen Druckprozess aufgebracht wird. Sensoren können auch eingesetzt werden, um den Reifegrad oder die Transportkette von Lebensmitteln zu überwachen. Diese Sensoren können dabei die Temperatur, die Lebensdauer des Produktes, den generellen Zustand des Produktes oder den Reifegrad über Reifegradindikatoren bestimmen.

Das funktionale Bauelement kann auch ein RFID-Transponder sein, der aus einer Antenne und einer Logik und gegebenenfalls weiteren funktionalen Elementen besteht. RFID Transponder sind in den vorherig angeführten Patenten ausführlich beschrieben. Der RFID-Transponder kann dabei ein aktiver oder passiver Transponder, oder ein so genannter 1-bit Transponder sein, wie er oftmals zur Warensicherung eingesetzt wird. In einer bevorzugten Ausführungsform wird eine Antenne mit einem leitfähigen Kleber gedruckt, dann vorzugsweise ein Chip oder eine Hilfsträger mit Chip (Strap-Technologie, Flip-Chip-Technologie) auf den Kontakten der Antenne unter Zuhilfenahme des gedruckten Klebers fixiert, anschließend die Antennenstruktur durch Bestäuben verstärkt, gegebenenfalls verdichtet und dann gegebenenfalls der Kleber gehärtet.

Das funktionale Bauelement kann auch ein Leuchtmittel oder ein Display sein. Eine neue Bauform von Leuchtdioden sind zum Beispiel organische Leuchtdioden (OLED). OLEDs beruhen auf dem Prinzip der Elektroluminiszenz. Hierzu ist die OLED meist in Form einer Sandwichstruktur aufgebaut, wobei zwischen zwei Elektroden eine Licht emittierende organische Schicht angeordnet ist. Einen Aufbau einer solchen OLED zeigt zum Beispiel die DE 10 2004 041 371. Weitere Ausprägungen von OLEDs zeigen die US 4,356,429, US 4,720,432 und die DE 10 2006 020 527. Eine gute Übersicht über die Licht emittierenden Polymere und Stoffe bietet die DE 699 20 803 T2 und die DE 11 2004 001 856 T5.
Die WO 99/39373 zeigt ein Verfahren zur Herstellung von OLEDS durch den Ink-Jet-Druck. Die WO 98/41898 offenbart ein druckbares elektronisches Display, das ein Substrat, ein druckbares elektrooptisches Material, wie eine Mikrokapseln, die eine Suspension eines elektrophoretischen Materials enthalten, Elektroden, die typischerweise auf einer transparenten leitfähigen Druckfarbe beruhen, Isolationsschichten, die auch drucktechnisch aufgebracht werden. Dazu kommt ein drucktechnisch hergestelltes nichtlineares Array zur Adressierung der Zellen.

Ein weiteres funktionales Bauelement kann ein elektrischer Energie-Speicher, zum Beispiel eine Batterie, sein. Ein solches galvanisches Element zeigt unter anderem die EP 0 633 620 B1. Prinzipiell lassen sich Anode, Kathode, aber auch die elektrolytischen Schichten drucktechnisch abbilden.

Das funktionale Bauelement kann auch eine Brennstoffzelle sein, wie sie als Energie- bzw. Antriebsquelle für Elektrofahrzeuge und anderen Anwendungen eingesetzt wird. Eine Brennstoffzelle weist dabei zum Beispiel eine katalytische Elektrode und ein elektrisch leitendes Kontaktelement auf. Ferner weisen die Brennstoffzellenschichten eine Beschichtung auf, die feinst verteilt katalytische Partikel enthalten. Eine Brennstoffzelle wandelt H2 und 02 bzw. Luft in elektrische Energie um. Ein gattungsgemäßer Vertreter einer solchen Brennstoffzelle ist unter anderem in der DE 103 93 838 T5 beschrieben.

Das funktionale Bauelement kann auch ein Photovoltaikanlage sein, zum Beispiel eine Solarzelle. Die Solarzellen weisen photosensitive Halbleiter auf, die aus Licht elektrischen Strom formen. Der elektrische Strom muss dann mit elektrischen Leiterbahnen aus der Photovoltaikzelle weggeführt werden. Es gibt dabei Photovoltaikanlagen, die mit anorganischen oder organischen Halbleitern arbeiten. Gattungsgemäße Vertreter einer solchen Photovoltaikanlagen sind in der DE 10 2005 003 846 und in der WO 02/05294 zu finden. Gemäß der WO 02/05294 wird die elektrisch leitfähige Lage einer solchen Photovoltaiklage durch eine leitfähige Druckfarbe gebildet.

Ein funktionales Bauelement kann auch ein Datenspeicher sein, der zwei oder mehr Elektroden enthält, die ein Halbleitermaterial einschließen und eine Passivierungsschicht, wobei der organische Halbleiter benachbart zu der Passivierungsschicht angeordnet werden kann. Ein gattungsgemäßer Vertreter eines solchen Speicherelements zum Speichern von Daten zeigt die DE 11 2004 001 855 T5.

Das wesentliche Problem der angewandten Drucktechniken zum Verdrucken von funktionalen Elementen besteht aber darin, dass immer ein Kompromiss zwischen den funktionalen und den drucktechnischen Anforderungen der Druckfarbe gefunden werden muss. Bei einer leitfähigen, gefüllten Druckfarbe zum Beispiel steht ein hoher Füllungsgrad mit leitfähigen Partikeln einer guten Verdruckbarkeit entgegen. Wird der Anteil der funktionalen Partikel abgesenkt um eine gute Verdruckbarkeit zu sichern, sinkt aber im Regelfall die Funktionalität der gedruckten Schichten. Auch führen die in die Druckfarben inkorporierten Partikel in der Regel zu einer verringerten Kantenschärfe und somit zu einem Verlust von Detailauflösung, wodurch viele Funktionalitäten negativ beeinflusst werden.

Es besteht also die Aufgabe, eine strukturierte Funktionsschicht auf effektive und kostengünstige Weise herzustellen.

Diese Aufgabe wird gelöst durch die Merkmale einer drucktechnisch erzeugten funktionalen Schicht nach Patentanspruch 1, ein Verfahren zur Herstellung von Multilayeranordnungen nach Anspruch 2 und eine Multilayeranordnung nach Anspruch 11.

Sinnvolle Weiterbildungen und Anwendungen dieser Technik ergeben sich aus den jeweiligen Unteransprüchen.

Die erfindungsgemäß gefundene Lösung besteht folglich darin, den Strukturierungsvorgang durch Drucktechniken oder anderen Funktionalisierungstechniken von der Funktionalisierung der Druckschichten weitgehend zu trennen.

Erfindungsgemäß wird ein Verfahren vorgeschlagen, nach dem ein Substrat in klebrige oder nicht klebrige Bereiche eingeteilt wird, wobei die klebrigen Bereiche den gewünschten funktionalen Strukturen entsprechen und dass die funktionalen Partikel unter Anwendung eines elektrischen Feldes auf das Substrat flächig oder partiell aufgebracht werden. Dabei werden die funktionalen Partikel in dem elektrischen Feld beschleunigt und dringen dabei in die klebrige Schicht ein. Dies hat den Vorteil, dass sich die funktionalen Partikel nicht nur an der Oberfläche der klebrigen Schicht anlagern, sondern auch in diese eindringen. Dies führt zu einer homogeneren Verteilung und besseren Haftung der funktionalen Partikeln in der klebrigen Schicht.

Das Substrat umfasst dabei alle Materialien, auf die eine erfindungsgemäße erste strukturierte klebrige Schicht übertragen werden, die anschließend in einem elektrischen Feld mit funktionalen Partikeln versehen wird, um die gewünschte Funktionalität zu erzielen. Substrate im Sinne der Erfindung können dabei Papier und Karton, Kunststofffolien, Kunststoffplatten, Verbundmaterialien, Glass oder Keramik sein.

Klebrige im Sinn der Erfindung meint, dass die Oberfläche eine Klebkraft aufweist, die die funktionalen Partikel auf der Oberfläche zu mindestens temporär auf dieser fixiert. Die Klebrigkeit kann durch das Aufdrucken einer klebrigen Schicht oder einer Schicht, die durch eine nachträgliche Behandlung, zum Beispiel eine Wärmebehandlung einer thermoplastischen Masse, durch das Anfeuchten eines Anfeuchteklebers, durch eine mechanische oder chemische Behandlung der Substratoberfläche, erzeugt werden. Eine klebrige Druckfarbe umfasst alle Druckfarben, die es erlauben die funktionalen Partikeln auf der Substratoberfläche zu fixieren. Dies kann eine normale Druckfarbe, vorzugsweise eine transparente Druckfarbe sein, die vorzugsweise so eingestellt ist, dass sie nicht vor dem Applizieren getrocknet ist und somit ihre Klebekraft verliert, aber auch eine spezielle Kleberausführung, die mit drucktechnischen Mitteln auf das Substrat aufgetragen werden kann. Die Härtung des aufgedruckten Klebemittels kann dabei durch Wegschlagen von Bindemittelbestandteilen in das Substrat, durch thermisch oder radikalisch oder kationisch induzierte Polymerisation und/oder durch Evaporation eines oder mehrerer Lösemittel geschehen. Als Druckverfahren für den Auftrag der klebrigen Druckfarbe kommen Offsetdruck, Flexodruck, Tiefdruck, wobei die Druckverfahren mit ihren Druckformen direkt oder über Zwischenträger mit dem Substrat stehen, zur Anwendung. Auch können so genannte Non-Impact-Druckverfahren für die Erzeugung des klebrigen Musters zur Anwendung kommen. Vertreter der Non Impact Druckverfahren sind unter anderem der Tintenstrahldruck, der xerographische Druck, der Laserdruck und andere elektrophotographische, elektrostatisch oder magnetische arbeitende Druckverfahren. Die klebrige Schicht kann auch in einem Lasertransferverfahren, bei dem von einem Transferverband partiell unter Zuhilfenahme eines Lasers Material auf das Substrat übertragen wird. Das in einem der Druckverfahren aufgetragene Klebstoffmuster entspricht dabei der später gewünschten funktionalen Struktur.

Die klebrige, strukturierte Schicht kann dabei keine zusätzliche Funktionalität neben der Klebrigkeit aufweisen. Die funktionalen gewünschten Eigenschaften, zum Beispiel die elektrische Leitfähigkeit, wird dann ausschließlich nachträglich durch das Einbringen von funktionalen Partikeln in klebrige Schicht in einem elektrischen Feld erzeugt. Die klebrige, strukturierte Schicht kann aber auch schon eine gewisse funktionale Grundfunktionalität neben der Klebrigkeit aufweisen, in dem in die klebrige Druckfarbe schon eine gewisse funktionale Elemente, die zum Beispiel schon eine gewisse elektrische Leitfähigkeit der klebrigen Schicht erzeugen, enthält. In diesem Fall wird die Funktionalität der strukturierten klebrigen Schicht durch die Beaufschlagung der Schicht mit funktionalen Partikeln in dem elektrischen Feld verstärkt bzw. verändert. Die in der Druckfarbe enthaltenden funktionalen Partikel können identisch sein zu den später in dem elektrischen Feld beaufschlagten funktionalen Partikeln, aber die Partikel können sich aber auch durchaus in der Art und / oder in der Funktionalität unterscheiden. Eine Beispiel hierfür wäre zum Beispiel eine klebrige Druckfarbe, die organisch leitfähige halbleitenden Polymere beinhaltet, die im nachfolgenden Schritt in dem elektrischen Feld mit anorganischen Halbleitermaterialien beaufschlagt wird und somit letztendlich eine funktionale strukturierte Schicht aus organischen und anorganischen halbleitenden Elementen gebildet wird. Die klebrige Schicht kann auch ein Reduktionsmittel, zum Beispiel Formaldehyd, enthalten, das eventuell oxidierte Oberflächen der funktionalen Partikel reduziert. Das Reduktionsmittel kann erforderlichenfalls nach dem Funktionalisierungsschritt der Schicht durch das Bestäuben mit den funktionalen Partikeln in dem elektrischen Feld aus der Schicht, zum Beispiel durch Wärmeeinwirkung ausgetrieben werden. Andere geeignete Reduktionsmittel sind unter anderem Natrium Borohydrid, Natrium Hypoborat, oder Dimethylamin boran. Die klebrige Schicht kann auch Alkohole enthalten, die ein gewisses Versintern der Partikel fördern. Die klebrige Schicht kann auch chemische Zersetzungsmittel enthalten, die Partikel aus einem Metallvorläufer zu einem reinen Metall zersetzen.

Nach der Beaufschlagung der klebrigen Schicht in dem elektrischen Feld muss die klebrige Schicht ihre Klebrigkeit verlieren, damit weitere Arbeitschritte folgen können. Die Klebrigkeit verliert die Schicht im einfachsten Fall, indem so viele funktionale Partikel in dem elektrischen Feld aufgetragen werden, dass möglichst keine oder nur eine geringe Klebefläche zur Verfügung steht. Die Klebrigkeit kann aber auch durch einen nach geordneten Trocknungs- oder Härtungsschritt erfolgen. Die Härtung kann durch Wärmeeinwirkung, zum Beispiel durch einen Infrarotstrahler, durch einen Laserbehandlung, und oder durch das Beaufschlagen von vorzugsweise erwärmter Luft beschleunigt werden. Im Falle von strahlenhärtenden klebrigen Schichten kann die Härtung durch Bestrahlung durch UV-Licht oder durch E-lektronenstrahltrocknung erfolgen. Eine weitere Möglichkeit besteht in der Trocknung von Schichten durch Induktionstrocknung, indem durch Induktion die Schichten erwärmt und getrocknet werden. Eine weitere Möglichkeit zur Härtung der Klebrigen Schichten besteht durch die Einbringung von Ultraschall oder Mikrowellenstrahlung in diese Schichten. Bei geeigneten funktionalen Elementen oder Bindemitteln in der klebrigen Schicht führt dies zu einer schnellen Trocknung und / oder Polymerisation der funktionalen Schicht. Bei einem Einsatz eines Wegschlagenden Substrates, kann die Trocknung auch durch Wegschlagen von Kleberbestandteilen in den Bedruckstoff erfolgen. Die Trocknung kann aber auch - mit und oder Trocknereinwirkung - durch chemische Oxidation erfolgen. Die hier aufgeführten Trocknungs- und Härtungsmechanismen lassen sich dabei in beliebiger Form miteinander kombinieren.

Die Trocknung bzw. Härtung der klebrigen Schicht kann aber auch dadurch erfolgen, dass nach dem Beaufschlagen der klebrigen Schicht mit den funktionalen Partikeln ein weiterer Bearbeitungsschritt erfolgt, bei dem eine Flüssigkeit oder eine Paste aufgetragen wird, die mit der klebrigen Schicht derart interagiert, dass die Klebrigkeit herabgesetzt oder vollständig beseitigt wird.

Die überschüssigen funktionalen Partikel, die dabei nicht durch die klebrige Schicht fixiert wurden, müssen vorzugsweise nach dem Verlust der Klebrigkeit der funktionalen Schicht von dem übrigen Substrat entfernt werden. Dies kann durch mechanische wirkende Mittel, wie Bürsten, Tücher, Rakel, Walzen oder andere geeigneten mechanischen Mittel geschehen. Die Partikel können dabei auch auf der Substratoberfläche durch Blasluft, durch Ultraschall oder durch mechanische Schwingungen, die in das Substrat eingebracht werden, so gelockert werden, dass sie nach dem Auflockern vollständig und einfach von der Substratoberfläche entfernt werden können. Die überschüssigen funktionalen Partikel werden von der Substratoberfläche vorzugsweise abgesaugt. Die überschüssigen funktionalen Partikel können aber auch von der Substratoberfläche abgenommen werden, indem sie zum Beispiel mit einer klebrigen Oberfläche, zum Beispiel einer Walze mit einer klebrigen Oberfläche, von der Substratoberfläche abgenommen werden. Die Entfernung der überschüssigen funktionalen Partikel kann aber auch elektrostatisch oder magnetisch erfolgen. Die hier aufgeführten Reinigungsverfahren und - mittel können dabei in beliebiger Weise miteinander kombiniert werden.

Vor dem Reinigungsschritt kann dem Beaufschlagen der klebrigen Schicht mit den funktionalen Partikeln ein Neutralitätsschritt erfolgen, bei dem die Ladung auf der Substratoberfläche neutralisiert wird, um den Reinigungsvorgang zu erleichtern. Dies kann durch eine berührende Erdung des Substrats, zum Beispiel über eine Walze oder durch eine kontaktlose Neutralisierung über eine so genannte Entladungselektrode erfolgen.

Die strukturierte funktionale Schicht kann nach dem Reinigungsschritt einem Verdichtungsschicht und gegebenenfalls erforderlichen Glättungsschritt unterworfen werden. Dies kann durch mechanischen Druck, zum Bespiel durch eine Walze, die unter Druck über die funktionale Schicht läuft, oder durch Ultraschall geschehen.

Bevor weitere Arbeitschritte, zum Beispiel das Applizieren weiterer funktionaler Lagen erfolgen, ist es sinnvoll die Funktionalität der funktionalen Struktur zu überprüfen. Dies kann einerseits visuell durch eine Kamera mit nach geschalteter Bildverarbeitung erfolgen, bei der die Struktur zum Beispiel auf Risse oder Kurzschlüsse untersucht wird. Dies kann aber auch dadurch erfolgen, dass zum Beispiel eine elektrische Leitfähigkeit kontaktend, z.B. durch einbringen von Messspitzen in die funktionale Lage, untersucht wird. Die funktionale Lage kann auch berührend oder berührungslos durch die Einkoppelung von Ultraschall in die funktionale Lage überprüft werden. Je nach Morphologie und Struktur pflanzt sich der Ultraschall in der funktionalen Schicht als Oberflächenwelle fort. Tritt an einer Stelle verstärkt Ultraschall aus, so lässt dies auf einen Defekt oder eine Störung der Morphologie der Schicht schließen. Die Qualitätssicherungsmaßnahmen können hierbei in beliebiger Art miteinander kombiniert werden.

Die funktionale Schicht kann danach durch eine Schutzschicht abgedeckt werden. Die Schutzschicht kann dabei auch gegebenenfalls die Funktion eines Isolators übernehmen. Die Schutzschicht kann ein Lack, eine Folie, die auflaminiert oder aufkaschiert wird, oder eine Transferschicht sein, die sich auf einem Folienträger befindet und von diesem mittels eines Prägevorgangs oder eines Haftvermittlers auf das Substrat und gegebenenfalls die funktionale Schicht transferiert wird.

Nach dem letzten Arbeitschritt können weitere Lagen aufgebracht werden. Die können in demselben Verfahren, wie oben geschildert, aufgebracht werden, bzw. mit anderen Methoden appliziert werden. Ist zum Beispiel keine weitere Strukturierung mehr nötig, kann die nächste funktionale Schicht in einem Guss- oder Walzenstreichverfahren aufgetragen werden.

Der Begriff "funktionale Schichten", "funktionale Partikel" oder "funktionale Druckfarben" bezieht sich auf funktionales Material und dessen Verwendung, wobei das funktionale Material mindestens eine Eigenschaft hat, die nicht dekorativ ist. Ungeachtet dessen können funktionale Materialien auch dekorative Eigenschaften haben. Die funktionale Eigenschaft des Materials kann inhärent sein, oder durch eine Behandlung des Materials erzielt werden. Die funktionale Eigenschaften können dabei durch physikalische und / oder chemische Manipulationen des Materials, oder durch Wechselwirkungen entlang und mit dem Substrat oder anderen Materialien erzielt werden.

Funktionale Partikel im Sinne der Erfindung, die in einem elektrischen Feld auf eine klebrige Schicht übertragen werden sind unter anderem Folgende:

### 1. Elektrisch leitfähige metallische Partikel

Die elektrisch leitfähigen funktionalen Partikel umfassen Partikel, die vollständig oder partiell aus Metallen bestehen, die selektiert aus der Gruppe von Metallen bestehend aus Silber, Gold, Kupfer, Zink, Zinn, Nickel, Palladium, Titan, Eisen, Chrom, Aluminium, Blei, Magnesium, Wolfram, Platin, Ruthenium, Rhodium, Osmium, Iridium, Zirkonium, Hafnium, Vanadium, Niob, Tantal, Molybdän, Technetium, Rhenium, Beryllium, Cadmium, Kobalt, Mangan, Nickel, Vanadium oder deren Legierungen oder Oxiden gebildet werden. Geeignete mehr oder weniger leitfähige Oxide sind unter anderem Zinnoxide, Indium(III)-oxide, fluoriertes Zinnoxide, Indiumzinnoxid (ITO), Wolframoxid, Titanoxid, Zinkoxid, Lanthanoxid, Nioboxid, Strontiumoxide, Vanadiumoxide, Zirkonoxide, Molybdänoxide oder deren Mischungen und Legierungen. Die Metalle können dabei in reiner Form vorliegen oder auf sich auf einem Trägermaterial, zum Beispiel einem Glimmerplättchen, befinden. Auch können die Partikel schichtweise aufgebaut sein, indem sie zum Beispiel aus einem Kupferkern bestehen, der mit einem Silberüberzug vor Oxidation geschützt ist. Die metallischen Partikel können ebenfalls eine Deckschicht aus einem leitfähigen Polymer aufweisen, der die Partikel vor Oxidation schützt und gleichzeitig die Anhaftung der Partikel untereinander verbessert. An die Partikel können weitere chemische Verbindungen angelagert sein. Die Partikel können dabei in Flakeform, als runde oder stäbchenförmige Partikel und in jeder beliebigen Zwischenform oder Formmischung auftreten. Bei dem Applikation im elektrischen Feld kann ein Metall allein oder in einer Kombination mit einem anderen funktionalen Partikel, zum Beispiel einem anderen Metall, aufgetragen werden.

### 2. Halbleitende metallische Partikel

Die halbleitenden funktionalen metallischen Partikel stammen aus der Gruppe der Halbmetalle, die gebildet wird aus Antimon, Arsen, Wismut, Bor, Germanium, Polonium, Selen und Silizium. Die halbleitenden metallischen Partikel können dabei auch an der Oberfläche beschichtet sein, zum Beispiel mit einem halbleitenden oder leitenden Polymer. Die Halbmetalle können dabei in amorpher oder kristalliner Form, bzw. in jeder denkbaren Zwischenform auftreten. Die halbleitenden Partikel können auch aus der Gruppe der Metalloxide gebildet sein.

### 3. Metallvorgänger und metallische Verbindungen

Funktionale Partikel, die ganz oder teilweise aus einem Metallvorgänger gebildet werden, der aus folgender Gruppe stammt: Goldacetat, Silberacetat, Palladiumoxalat, Silber 2-ethylhexanoate, Kupfer 2-ethylhexanoate, Eisenstearate, Zinkcitrat, Silbernitrat, Kupfercyanid, Kobaltcarbonat, Platinchlorid, Tetrabutoxytitanium, diemethoxyzirkonium dichloride, Aluminium isopropoxide, Zinn tetrafluorborate, Vanadiumoxid, Indium-Zinnoxid, Tantalmethoxide, Bismuthacetat, Indium acetyacetonate oder anderen Metallverbindungen mit Nebengruppen aus Wasserstoff, Ammonium, Sauerstoff, Schwefel, Halogen, Cyano, Cyanat, Karbonat, Nitrat, Nitrit, Sulfat, Phosphat, Thiocyanat, Chlorat, Perchlorat, Tetrafluoroborat, Acetylacetonat, Amid, Alkoxid, Caboxylat und deren Derivate.

### 4. Leitfähige oder halbleitfähige Polymere

Funktionale Partikel, die ganz oder teilweise aus einem leitfähigen Polymer gebildet aus der Gruppe der leitfähigen Polymere bestehend aus Polyanilin (PANI), Polythiophen (PTh), Poly (3,4-ethylendioxythiophen) (PEDT), Polythieno-thiophen (PTT),Polydiacetylen, Polyacetylen (PAc), Polypyrrol (PPy), Polyisothianaphthen (PITN), Polyheteroarylenvinylen (PArV), Poly-p-phenylen (PpP), Polyphenylensulfid (PPs), Polyperinaphtalin (PPn), Polypthalocyanin (PPc), und deren Derivate gebildet werden.

### 5. Photokatalytisch aktive Materialien

Funktionale Partikel, die ganz oder teilweise aus photokatalytisch aktiven Materialien ausgebaut sind. Beispiele hierfür sind Titandioxid und Zinkoxid und andere geeignete Metalloxide, wobei Metalle, wie Platin, Palladium, Kupfer oder andere geeignete Metalle als Cokatalysatoren oder als Dotierung benutzt werden können. Als Dotierung für Titandioxide sind z.B. Eisen, Palladium oder Platin zweckmäßig.

### 4. Russe, Nanoröhren, Graphit

Funktionale Partikel, die ganz oder teilweise aus leitfähigen Russen, aus Nanoröhren, Fullerene oder fullerenähnliche Molekularkäfige oder aus Graphit aufgebaut sind.

### 5. Gläser

Funktionale Partikel, die aus Gläsern geformt wurden oder diese beinhalten. Die Gläser können aus Quarzglas, Borosilikatglas, Phosphorsilikatglas, Borophosphorsilkatglas oder Kristallglas bestehen. Die Gläser können andere Komponenten enthalten, wie zum Beispiel Kalzium, Natrium, Aluminium, Blei, Lithium, Magnesium, Barium, Kalium, Bor, Beryllium, Phosphor, Gallium, Arsen, Antimon, Lanthan, Zink, Thorium, Kupfer, Chrom, Mangan, Eisen, Kobalt, Nickel, Molybdän, Vanadium, Titan, Gold, Platin, Palladium, Silber, Cer, Cäsium, Niob, Tantal, Zirkonium, Neodym, Praseodym, welche in Form von Oxiden, Karbonaten, Nitraten, Phosphaten, und / oder Halogeniden in den Gläsern auftreten oder als Dotierungselementen in den Gläsern funktionieren.

### 6. Nicht leitfähige Polymere

Die funktionalen Partikel können aus beliebigen elektrisch isolierenden Polymeren bestehen, die zum Beispiel für die Ausbildung einer Isolationsschicht (Dieelektrika) dienen können.

### 7. Lichtemittierendes Polymer

Die funktionalen Partikel können ein Licht emittierendes Material beinhalten oder aus diesem bestehen. Die Partikel können dabei einen Farbstoff enthalten oder aus diesem bestehen. Geeignete Farbstoffe sind zum Beispiel Derivate von Poly (p-phenylen-Vinylen) oder metall-organische Komplexe, bei denen die Lichtaussendung aus Triplett-Zuständen erfolgt (Phosphoreszenz). Die Erfindung umfasst auch alle anderen geeigneten Licht emittierenden Materialien.

### 8. Lichtabsorbierende Partikel

Die funktionalen Partikel können Partikel sein, bei denen eine Umwandlung von Strahlungsenergie in elektrische Energie stattfindet. Die Partikel können organisch, anorganisch oder Hybrid anorganisch/organischer Art sein, wobei anorganische und organische Materialien gleichzeitig oder in einem Partikel angewandt werden. Die organischen Materialien umfassen Farbstoffe und Pigmente, wie zum Beispiel Perylene, Phtalocyanine, Terylene und deren Derivate oder geeignete Polymere.

### 9. Elektrolyten

Die funktionalen Partikel können elektrolytische Eigenschaften haben. Geeignete Elektrolyte sind Polymerelektrolyte, lonomere, Oxidkeramische Elektrolyte, Natriumaluminate, YSZ (eine Mischung aus Zirkoniumoxid und Ybitteriumoxid) und andere geeignete Elektrolyte und Elektrolytmischungen. Elektrolyte können auch biologisch wirksame Elektrolyte sein. Diese sind Elektrolyte, wie Natrium, Kalium, Calcium, Magnesium, Phosphate und Hydrogencarbonat.

### 10. Mikrosphären

Die funktionalen Partikel können auch polymerische Mikrosphären sein, die ein funktionales Material enthalten. Das funktionale Material kann ein metallisches, ein polymeres oder ein biologisches Produkt oder ein Gas sein. Mikrosphären haben auch den Vorteil, dass Gase und Flüssigkeit in die Schicht eingebracht werden können, die ansonsten nur schwer applizierbar sind.

### 11. Katalysatoren, Enzyme

Die funktionalen Partikel können selber einen Katalysator sein, zum Beispiel ein metallischer Katalysator, oder diesen beinhalten. Der Begriff Katalysator umfasst dabei auch im Sinne der Erfindung Enzyme.

### 12. Biomarker

Die funktionalen Partikel können auch Biomarker sein, die in einem Kontakt mit einem biologischen Gut eine Reaktion zeigen. Die Partikel können dabei aus den Biomarkern bestehen oder diese beinhalten. Ein Beispiel für einen solchen Biomarker sind Marker, die den Zuckergehalt im Blut anhand einer unterschiedlichen Färbung anzeigen.

### 13. Hydrophobe Partikel

Die funktionale Partikel können hydrophobe Partikel sein, die zum Beispiel zur Strukturierung von Flächen dienen. Beispiel für solche hydrophobe Materialien sind Polytetrafluorethylen oder Silicon.

### Ausführungsbeispiele für die elektrische Aufladung von Partikeln:

### 1. Tribolektrische Aufladung

Die Partikel können durch triboelektrische Aufladung aufgeladen werden
Die triboelektrische Aufladung kann dabei auf verschiedener Weise geschehen. Bei einem Verfahren werden die Partikel gezwungen eine andere Oberfläche in einer rollenden, gleitenden oder stoßenden Bewegung zu beaufschlagen. Dies kann zum Beispiel in einem Vorratsbehälter geschehen, in dem die Partikel verwirbelt werden oder durch den Kontakt mit den Wänden eines Transportkanals. Ein weiteres Verfahren besteht darin, die Partikel in einem aufgeladenen Fluid zu transportieren, welches die Ladung auf die Partikel überträgt. Ein anderes Verfahren besteht darin, die Teilchen unterschiedlich schnell zu beschleunigen, was zu einer Reibung zwischen den Partikeln und somit zu einer Aufladung führt. Die triboelektrische Aufladung der Partikel kann auch durch eine so genannte magnetische Bürste geschehen. Eine gute Übersicht über die Technologie der magnetischen Bürsten bietet die US 3,863,603. Die erfindungsgemäße Lösung umfasst jedoch ausdrücklich alle geeigneten Formen der triboelektrischen Aufladung, auch wenn sie in dieser beispielhaften Ausführung nicht explizit erwähnt werden.

### 2. Kontaktaufladung

Die Partikel können aufgeladen werden, in dem sie mit einem mit einem bestimmten Potential aufgeladen Material in Kontakt kommen. Dies kann ein Förderband sein, eine Trommel oder ein Sieb, bei dem die Partikel während des Durchgangs durch die Öffnung eine bestimmte Ladung erhalten. Die Erfindung umfasst ausdrücklich alle geeigneten Formen der Kontaktaufladung, auch wenn sie in dieser beispielhaften Ausführung nicht explizit erwähnt werden.

### 3. Aufladung in einem Koronafeld

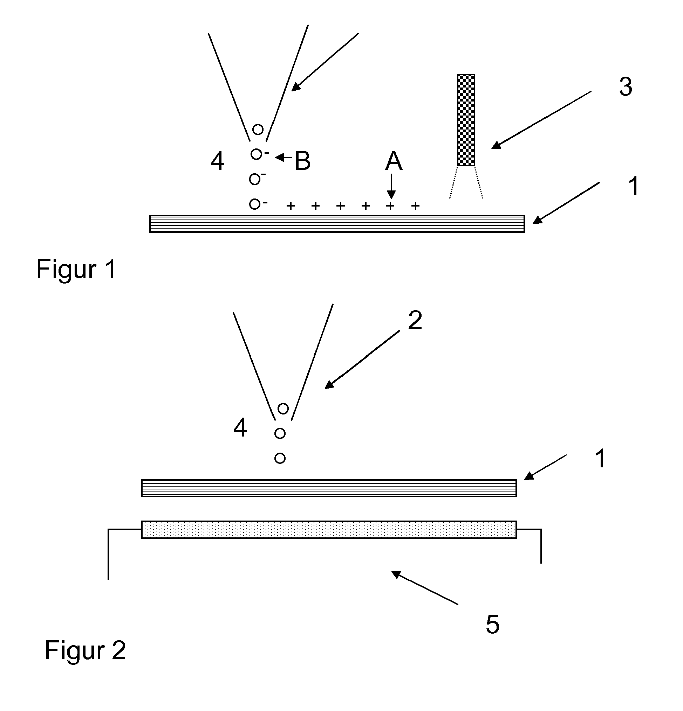

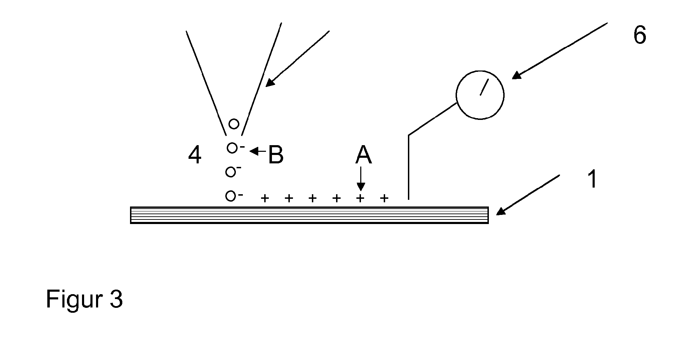

Die Partikel können auch in einem Koronafeld aufgeladen werden. Dabei werden die Partikel meist in einem Gasstrom zwischen zwei Elektroden durchgeführt, wobei eine Elektrode eine Hochspannung trägt und die andere Elektrode meist geerdet ist. Dabei bildet sich zwischen den Elektroden ein elektrisches Feld aus, das zu einer Aufladung der Partikel führt. Durch die Steuerung und Modulation der E-lektrodenspannung kann der Partikelfluss beeinflusst werden. Die Erfindung umfasst ausdrücklich alle geeigneten Formen der Koronaaufladung, auch wenn sie in dieser beispielhaften Ausführung nicht explizit erwähnt werden.
Für die Applikation der Partikel werden verschiedene Varianten vorgeschlagen. Die nachfolgende kurze Beschreibung bezieht sich auf die hierzu erläuternd beigefügten Figuren 1 bis 3:

### Ausführungsbeispiel 1:

Das Substrat (1) mit dem darauf gedruckten Kleberspuren wird durch eine Gleichspannungskorona (Ladungselektrode) (3) vor dem Passieren des Applikationsspaltes (4), der zwischen der Applikationsvorrichtung (2) und dem Substrat (1) ausgebildet ist, mit einem Potential (A) aufgeladen, während die Partikel mit dem entgegengesetzten Potential (B) aufgeladen werden.

### Ausführungsbeispiel 2:

Das Substrat (1) mit dem darauf gedruckten Kleberspuren wird in Applikationsspalt (4) eingeführt, der zwischen der Applikationsvorrichtung (2) und dem Substrat (1) ausgebildet ist, wobei unterhalb des Substrates (1) eine Gegenelektrode (5) angeordnet ist, die ein elektrisches Feld erzeugt, indem die gegenpolig geladenen Partikel (B) beschleunigt werden.

### Ausführungsbeispiel 3:

Das Substrat (1) weist gedruckte Klebespuren auf, die aus einem leitfähigen Kleber gebildet sind. Diese Klebespuren werden durch eine oder mehrere elektrische Kontaktstifte (6) kontaktiert und geerdet oder mit einer Spannung versehen, die eine Polarität (A) hat, die der Polarität (B) der Partikel entgegengesetzt ist.

### Ausführungsbeispiel 4:

Die Partikel werden in einem Gasstrom beschleunigt und auf das Substrat mit einer solchen Kraft aufgeblasen, so dass sie zu mindestens teilweise in die Kleberschicht eindringen.

Zusammengefasst ist also erfindungsgemäß ein Verfahren zur Herstellung einer drucktechnisch erzeugten funktionalen Schicht durch das strukturierte Vordrucken eines Klebers in einem Druckwerk oder einer Druckvorrichtung auf einem beliebigen Substrat vorgesehen. Die Funktionalität besteht im Wesentlichen darin, dass durch das Bestäuben der vorher gedruckten Kleberschicht mit pulvrigen funktionalen Partikeln eine Funktionsschicht erzeugt wird.
Erfindungswesentlich ist dabei, dass die drucktechnisch und durch Bestäubung erzeugte strukturierte Schicht (Funktionsschicht) Bestandteil einer Multilayeranordnung, also einer mehrschichtigen Anordnung, wie einer elektronischen Schaltung, ist. Die Multilayeranordnung umfasst neben der ersten Schicht (Funktionsschicht) mindestens eine weitere zweite gedruckte oder beschichtete funktionale Schicht. Die Funktionalitäten der Schichten werden entweder durch mindestens zwei unterschiedliche Materialien gebildet. Möglich ist es auch, dass sich die gedruckten bzw. beschichteten und gegebenenfalls bestäubten Schichten derart in ihrem Grad der Funktionalität unterscheiden oder in einer solchen vorbestimmten Relation auf dem Substrat angeordnet sind, dass sie nicht in einem einzigen Druck-, Bestäubungsvorgang und / oder. Beschichtungsvorgang innerhalb eines einzigen Druck- bzw. Beschichtungsdurchlaufes erzeugt werden können.

Zum Aufbringen der Kleberschicht wird bei der Herstellung einer Multilayeranordnung mindestens eine strukturierte Kleberspur erzeugt, die anschließend mit funktionalen Partikeln bestäubt wird. Die Kleberspur kann dabei im Offset-, Tief-, Flexo-, Sieb- oder Tintenstrahldruck aufgetragen werden.

Vorteilhaft ist, wenn der Bestäubungsvorgang in einem elektrischen Feld erfolgt, wobei die funktionalen Partikel mit einer definierten Ladung aufgeladen und in Richtung einer Gegenelektrode beschleunigt werden. Für die Aufladung der funktionalen Partikel sind vielfältige technische Möglichkeiten gegeben: durch triboelektrische oder Kontaktaufladung oder Koronaaufladung erfolgt. Es ist auch möglich vor dem Applizieren der Partikel das Substrat durch eine Gleichspannungskoronaanlage mit einer Ladung zu versehen, so dass es selbst die Gegenelektrode bildet, deren Polarität entgegengesetzt zur Polarität der geladenen funktionalen Partikel ist. Wenn die Gegenelektrode unterhalb des Substrates angeordnet ist, kann sie als Platte, als elektrostatisch geladenes Förderband oder als Zylinder oder in einer anderen geeigneten Form ausgebildet sein. Die Gegenelektrode kann aber auch durch die Kleberspur gebildet werden. Dazu muss der Kleber eine gewisse elektrische Leitfähigkeit aufweisen und durch Kontakte, wie zum Beispiel Kontaktstifte, geerdet sein. Sie kann auch mit einem Potential beaufschlagt werden, dessen Polarität entgegengesetzt zur Polarität der geladenen funktionalen Partikel gerichtet ist.

Grundsätzlich sollte die Funktionalität des drucktechnisch aufgetragenen Klebers nicht mit der Funktionalität der Partikel korrespondieren, da sonst die Wirkung der Partikel geschwächt werden kann.
Andererseits kann der aufgedruckte Kleber aber auch eine Funktionalität, wie z.B. eine elektrische Leitfähigkeit aufweisen, die mit der Funktionalität der aufgestäubten Partikel, wie einem elektrisch leitenden Partikel, gut korreliert bzw. korrespondiert.

Als Materialien für die funktionalen Partikel kommen verschiedene Werkstoffe in Frage.
Zunächst können metallische Partikel oder Partikel verwendet werden, die Metalle enthalten. Diese sind zu selektieren aus der Gruppe, die aus Silber, Gold, Kupfer, Zink, Zinn, Nickel, Palladium, Titan, Eisen, Chrom, Aluminium, Blei, Magnesium, Wolfram, Platin, Ruthenium, Rhodium, Osmium, Iridium, Zirkon, Hafnium, Vanadium, Niob, Tantal, Molybdän, Technetium, Rhenium, Beryllium, Cadmium, Kobalt, Mangan, Nickel, Vanadium oder deren Legierungen oder Oxiden gebildet werden. Weiterhin sind als weitere leitfähige Oxide Zinnoxid, Indium(III)-oxid, fluoriertes Zinnoxid, Indiumzinnoxid (ITO), Wolframoxid, Titanoxid, Zinkoxid, Lanthanoxid, Nioboxid, Wolframoxid, Strontiumoxid, Vanadiumoxid, Zirkoniumoxid, Molybdänoxid oder deren Mischungen und Legierungen geeignet für den genannten Einsatz geeignet.

Weiterhin kommen Halbleiter in Frage, die aus der Gruppe der Halbmetalle, wie Antimon, Arsen, Wismut, Bor, Germanium, Polonium, Selen und Silizium stammen. Dabei werden halbleitenden metallischen Partikel auch an der Oberfläche beschichtet oder sie werden mit einem halbleitenden oder leitenden Polymer versehen sein. Die Halbmetalle treten auch in amorpher oder kristalliner Form bzw. in jeder denkbaren Zwischenform auf und können aus der Gruppe der Metalloxide gebildet sein.

Die Partikel können auch als leitfähige oder halbleitende Polymere aus der Gruppe der leitfähigen Polymere ausgebildet sein. Dazu gehören Polyanilin (PANI), Polythiophen (PTh), Poly (3,4-ethylendi-oxythiophen) (PEDT), Polythienothiophen (PTT),Polydiacetylen, Polyacetylen (PAc), Polypyrrol (PPy), Polyisothianaphthen (PITN), Polyheteroarylenvinylen (PArV), Poly-p-phenylen (PpP), Polyphenylensulfid (PPs), Polyperinaphtalin (PPn), Polypthalocyanin (PPc), und deren Derivate und Mischungen.

Schließlich können funktionale Partikel auch photokatalytisch aktive Materialien sein, wofür Titandioxid und Zinkoxid und andere geeignete Metalloxide, wobei Metalle, wie Platin, Palladium, Kupfer oder andere geeignete Metalle als Cokatalysatoren oder als Dotierung benutzt werden können. In diesem Zusammenhang sind als Dotierung die Werkstoffe Titandioxid, Eisen, Palladium oder Platin zweckmäßig.

Außerdem können die funktionalen Partikel ganz oder teilweise aus leitfähigen Russen, aus Nanoröhren, Fullerenen oder fulleren-ähnlichen Molekularkäfigen oder aus Graphit oder deren Mischungen aufgebaut sein.

Außerdem können die funktionalen Partikel ganz oder teilweise polymere Mikrosphären sind, die einen funktionalen Stoff in einem festen, flüssigen oder gasförmigen Zustand beinhalten.

In dem Verfahren können zum Applizieren die funktionalen Partikel ganz oder teilweise aus Gläsern geformt werden oder diese beinhalten. Die Gläser bestehen aus Quarz-, Borosilikat-, Phosphorsilikat-, Borophosphorsilkat- oder Kristallglas. Sie weisen weitere Komponenten wie Kalzium, Natrium, Aluminium, Blei, Lithium, Magnesium, Barium, Kalium, Bor, Beryllium, Phosphor, Gallium, Arsen, Antimon, Lanthan, Zink, Thorium, Kupfer, Chrom, Mangan, Eisen, Kobalt, Nickel, Molybdän, Vanadium, Titan, Gold, Platin, Palladium, Silber, Cer, Cäsium, Niob, Tantal, Zirkonium, Neodym, Praseodym auf. Diese wiederum können als Oxide, Karbonate, Nitrate, Phosphate und / oder Halogenide in den Gläsern auftreten oder sie können als Dotierungselemente in den Gläsern wirken.

Die funktionalen Partikel können auch ganz oder teilweise aus elektrisch isolierenden Polymeren bestehen, die für die Ausbildung einer Isolationsschicht (Dieelektrika) ausgebildet sind.

Die funktionalen Partikel können auch ganz oder teilweise Licht emittierendes Material beinhalten oder aus diesem bestehen, wobei die Partikel einen Farbstoff enthalten oder auch ganz aus diesem bestehen können.

Weiterhin können die funktionalen Partikel ganz oder teilweise als photoaktive Partikel ausgebildet sein. Bei derartigen Partikeln findet eine Umwandlung von Strahlungsenergie in elektrische Energie statt. Die Partikel sind organisch, anorganisch oder als hybrid anorganisch / organischer Art ausgebildet und es können anorganische und organische Materialien gleichzeitig oder in einem Partikel miteinander angewandt werden.

Auch können die funktionalen Partikel als Ganzes oder teilweise elektrolytische Eigenschaften haben, wobei als geeignete Elektrolyte Polymerelektrolyte, lonomere, oxidkeramische Elektrolyte, Natriumaluminate, YSZ (Mischung aus Zirkonoxid und Ybitteriumoxid) und Elektrolytmischungen in Frage kommen.
Ebenso kommen Partikel mit katalytischen Eigenschaften in Frage, wobei neben metallischen Katalysatoren auch Enzyme verwendbar sind.

Besonders interessant scheint die Anwendung funktionaler Partikel als Biomarker. Diese treten in Interaktion mit einem biologischen Gut und zeigen hier eine Reaktion, Hierbei können die Partikel selbst Biomarker sein oder diese beinhalten. Als Biomarker können beispielsweise Stoffe verwendet werden, die den Zuckergehalt im Blut anhand einer unterschiedlichen Färbung anzeigen.

Schließlich können die funktionalen Partikel auch als hydrophobe Partikel zur Strukturierung von Flächen ausgebildet sein. Hierzu kommen Polytetrafluorethylen oder Silicon in Frage.

Bei der Herstellung eines Multilayers müssen überschüssige funktionale Partikel, die nach dem Bestäuben nicht an den gedruckten Kleberspuren anhaften, von der Oberfläche des Substrats entfernt werden.

Dies kann durch eine Saugvorrichtung geschehen. Alternativ kann eine mechanisch wirkende Reinigungsvorrichtung, zum Beispiel Bürsten, vorgesehen sein. Weiterhin können die überschüssigen Partikel durch eine Elektro- oder Festkörpermagneten von der Oberfläche entfernt werden.
Unterstützend zur besseren Entfernbarkeit wirkt es, wenn die überschüssigen Partikel durch eine Entladungsvorrichtung, zum Beispiel einer Wechselspannungskorona, elektrisch neutralisiert werden.

Weiterhin können überschüssige Partikel durch berührungslose Ultraschalleinwirkung auf der Oberfläche aufgelockert werden, so dass diese leichte entfernt werden können. Dies ist auch durch die kontaktierende Einkoppelung von Schwingungen in das Substrat möglich.

Vorzugsweise vor dem Arbeitsschritt des Entfernens überflüssiger, nicht mit der gedruckten Kleberspur verbundener Partikel sollte eine Härtung oder Trocknung des Klebers erfolgen. Dazu kann der Kleber als strahlen härtender Kleber mittels UV-Strahlung oder Elektronenstrahlung gehärtet werden. Die Härtung des Klebers kann auch durch Mikrowellenstrahlung oder durch Wärmeeinwirkung einer oder mehrerer Infrarot- oder Heißluftdüsen oder Ultraschalleinwirkung erfolgen.

Nach dem Aufbringen der Partikel und Reinigen der Partikel werden die Partikel, die an der Kleberspur anhaften oder in diese integriert sind, weiter verdichtet, um die Struktur der Partikellage zu verbessern. Hierzu können mechanische Mittel, zum Beispiel Walzen oder Reibbalken unter Druck auf die Partikellage einwirken. Dies kann auch berührungslos mittels Ultraschall, der von einem Ultraschallschwinger oder -wandler ausgesandt wird, erfolgen.

Die Struktur der Partikellage kann weiter verbessert werden, indem die Partikel, die an der Kleberspur anhaften oder in diese integriert sind, durch Wärmeeinwirkung soweit erhitzt werden, dass mindestens eine Komponente der beigemischten Partikel zu schmelzen beginnt und sich dadurch mit anderen Komponenten zu verbindet. Die Erwärmung kann durch flächiges Beaufschlagen des Substrats, z.B. durch einen Infrarotstrahler oder eine oder mehrere Heißluftdüsen erfolgen. Eine gezielte bildmäßige Erwärmung kann partiell, wie durch Laserstrahlen, erfolgen.
Die Härtung kann einseitig oder von beiden Seiten des Substrates erfolgen.

Wenn der Kleber ein oxidativ trocknender und / oder in das Substrat wegschlagend trocknender Kleber ist, wird auch die selbsttätige Trocknung unterstützt.

Die Multilayeranordnung selbst kann eine mehrlagige Leiterplatte mit Durchkontaktierungen sein. Hierbei können zwischen den einzelnen Lagen Prepregs eingefügt sein. Immer ist aber mindestens eine der strukturierten Lagen durch das erfindungsgemäße Herstellungsverfahren hergestellt.
Die Multilayeranordnung ist dabei als eine konventionell steife oder eine flexible, biegsame Leiterplatte ausgebildet.

Multilayeranordnungen sind mit vielfältigen Funktionalitäten herstellbar, wobei immer wenigstens eine der strukturierten Lagen nach dem erfindungsgemäßen Herstellungsverfahren erzeugt wurde.

Die Multilayeranordnung kann ein mindestens teilweise drucktechnisch hergestellter Transistor sein, wobei mindestens einer der funktionellen Lagen des Transistors, wie die Gate-Elektroden, die halbleitfähige Schicht, die isolierende Schicht oder die Gegenelektroden durch das erfindungsgemäße Verfahren hergestellt werden.

Die Multilayeranordnung kann auch eine Antenne eines RFID-Transponders sein, wobei der Kleber zum Fixieren der funktionalen Partikel und gleichzeitig zum Fixieren eines Chips oder eines Hilfsträgers (Strap-Technik, Flip Chip Technik) dient.

Weitere Anwendungsmöglichkeiten ergeben sich für die Multilayeranordnung, wenn sie eine oder mehrere organische Leuchtdioden (OLED) beinhaltet. Ebenso kann sie ein Display, wie zum Bespiel ein Multimatrixdisplay, sein. Weiterhin kann so eine Sensorvorrichtung, wie ein Biosensor, gebildet werden. Schließlich kann auf diese Weise eine Photovoltaikanlage, wie eine Solarzelle, hergestellt werden. Auch ist denkbar auf diese Weise eine gedruckte Batterie oder eine Brennstoffzelle herzustellen.

Zur Kennzeichnung und Verbesserung der Funktionalität kann die Multilayeranordnung zusätzlich mit aufgedruckten Farb- und Schriftinformationen versehen werden.

### Bezugszeichenliste

- A: Potential 1
- B: Potential 2
- 1: Substrat
- 2: Applikationsvorrichtung
- 3: Ladungsvorrichtung, zum Beispiel Coronaelektrode
- 4: Applikationsspalt
- 5: Gegenelektrode
- 6: Kontaktstifte oder ähnliche kontaktende Vorrichtungen

## Patentansprüche

1. Verfahren zur Herstellung einer drucktechnisch erzeugten funktionalen Schicht durch das strukturierte Vordrucken eines Klebers in einem Druckwerk oder eine Druckvorrichtung auf ein Substrat, wobei die Funktionalität im Wesentlichen durch das Bestäuben der Kleberschicht mit pulvrigen funktionalen Partikeln erzeugt wird, **gekennzeichnet dadurch, dass** die drucktechnisch und durch Bestäubung erzeugte strukturierte Schicht Bestandteil einer Multilayeranordnung ist, die neben der ersten Schicht mindestens eine weitere zweite gedruckte oder beschichtete funktionale Schicht umfasst, wobei die Funktionalitäten der Schichten entweder durch mindestens zwei unterschiedlichen Materialien gebildet werden, oder die gedruckten bzw. beschichteten und gegebenenfalls bestäubten Schichten sich derart in ihrem Grad der Funktionalität unterscheiden oder so auf dem Substrat angeordnet sind, dass sie nicht in einem Druck- und gegebenenfalls Bestäubungsvorgang bzw. Beschichtungsvorgang in einem Druck- bzw. Beschichtungsdurchgang erzeugt werden können.

2. Verfahren zur Herstellung einer Multilayeranordnung nach Anspruch 1, **gekennzeichnet dadurch, dass** mindestens eine strukturierte Kleberspur, die anschließend mit funktionalen Partikeln bestäubt wird, in einem der Druckverfahren Offset-, Tief-, Flexo-, Sieb- oder Tintenstrahldruck aufgetragen wird.

3. Verfahren zur Herstellung einer Multilayeranordnung nach Anspruch 1 oder 2, **gekennzeichnet dadurch, dass** der Bestäubungsvorgang in einem elektrischen Feld erfolgt, wobei die funktionalen Partikel mit einer definierten Ladung aufgeladen werden und in Richtung einer Gegenelektrode beschleunigt werden.

4. Verfahren zur Herstellung einer Multilayeranordnung nach Anspruch 1 bis 3, **gekennzeichnet dadurch, dass** überschüssige funktionalen Partikel, die nicht an den Kleberspuren anhaften durch eine Saugvorrichtung von der bestäubten Oberfläche abgesaugt werden oder durch eine mechanisch wirkende Reinigungsvorrichtung, zum Beispiel Bürsten, entfernt werden oder durch eine Elektro- oder Festkörpermagneten von der Oberfläche entfernt werden und dass wahlweise die Partikel durch einen Entladungsvorrichtung, zum Beispiel einer Wechselspannungskorona, elektrisch neutralisiert werden.

5. Verfahren zur Herstellung einer Multilayeranordnung nach Anspruch 1 bis 4, **gekennzeichnet dadurch, dass** die nicht an den Kleberspuren anhaftenden Partikel zur leichteren Entfernung auf der Oberfläche aufgelockert werden, wobei die Auflockerung durch berührungslose Ultraschalleinwirkung oder durch die kontaktierende Einkoppelung von Schwingungen in das Substrat auf der Oberfläche aufgelockert werden.

6. Verfahren zur Herstellung einer Multilayeranordnung nach Anspruch 1 bis 5, **gekennzeichnet dadurch, dass** die funktionalen Partikel, die an der Kleberspur anhaften oder in diese integriert sind, durch einen Arbeitsgang, der sich dem Bestäubungsvorgang anschließt weiter verdichtet werden, wobei die ,Verdichtung durch kontaktierende mechanische Mittel, wie Walzen oder Reibbalken unter Druck, oder durch berührungslose Einwirkung von Ultraschall, z.B. Ultraschall, der von Ultraschallschwinger oder -wandler ausgesandt wird, erfolgt.

7. Verfahren zur Herstellung einer Multilayeranordnung nach Anspruch 1 bis 6, **gekennzeichnet dadurch, dass** die funktionalen Partikel, die an der Kleberspur anhaften oder in diese integriert sind durch Wärmeeinwirkung soweit erhitzt werden, dass mindestens eine Komponente der beigemischten Partikel anfängt zu schmelzen und sich mit anderen Komponenten zu verbinden.

8. Verfahren zur Herstellung einer Multilayeranordnung nach Anspruch 7, **gekennzeichnet dadurch, dass** die Erwärmung der funktionalen Schicht durch ein flächiges Beaufschlagen des Substrats, wie durch einen Infrarotstrahler und/oder eine oder mehrere Heißluftdüsen erfolgt und / oder partiell, wie durch Laserstrahlen, erfolgt.

9. Verfahren zur Herstellung einer Multilayeranordnung nach Anspruch 1 bis 8, **gekennzeichnet dadurch, dass** vorzugsweise vor dem Arbeitsschritt des Entfernens überflüssiger, nicht mit der gedruckten Kleberspur verbundener Partikel ein Härtungs- oder Trocknungsschritt des Klebers erfolgt, wobei die Härtung von einer oder von beiden Seiten des Substrates erfolgen kann.

10. Verfahren zur Herstellung einer Multilayeranordnung nach Anspruch 1 bis 9, **gekennzeichnet dadurch, dass** der Kleber ein oxidativ trocknender und / oder in das Substrat wegschlagend trocknender Kleber ist.

11. Multilayeranordnung hergestellt in einem Verfahren nach Anspruch 1 bis 10, **gekennzeichnet dadurch, dass** die Multilayeranordnung eine mehrlagige Leiterplatte mit Durchkontaktierungen ist, wobei gegebenenfalls zwischen den einzelnen Lagen Prepregs eingefügt sind, und mindestens eine strukturierte Lage durch das erfindungsgemäße Herstellungsverfahren hergestellt ist, wobei die Leiterplatte als steife oder flexible, biegsame Leiterplatte ausgebildet ist.

12. Multilayeranordnung nach Anspruch 10 bis 12, **gekennzeichnet dadurch, dass** die Multilayeranordnung ein mindestens teilweise drucktechnisch hergestellter Transistor ist, wobei mindestens einer der funktionellen Lagen des Transistors, wie die Gate-Elektroden, die halbleitfähige Schicht, die isolierende Schicht oder die Gegenelektroden durch das erfindungsgemäße Verfahren hergestellt werden.

13. Multilayeranordnung nach Anspruch 10 bis 12, **gekennzeichnet dadurch, dass** die Multilayeranordnung eine Antenne einer RFID-Transponders ist, wobei der Kleber zum Fixieren der funktionalen Partikel und gleichzeitig zum Fixieren eines Chips oder eines Hilfsträgers (Strap-Technik, Flip Chip Technik) dient.

14. Multilayeranordnung nach Anspruch 10 bis 12, **gekennzeichnet dadurch, dass** die Multilayeranordnung eine oder mehrere organische Leuchtdioden (OLED) oder ein Display, wie ein Multimatrixdisplay, oder eine Sensorvorrichtung, wie ein Biosensor oder eine Photovoltaikanlage, wie eine Solarzelle, oder eine gedruckte Batterie oder eine Brennstoffzelle ist, wobei mindestens eine funktionale Lage der jeweiligen Multilayeranordnung durch das erfindungsgemäße Verfahren hergestellt wird.

15. Multilayeranordnung nach Anspruch 10 - 15,
**gekennzeichnet dadurch, dass**
zusätzlich Farb- und Schriftinformationen aufgedruckt werden.
